Europäisches Patentamt

European Patent Office

Office européen des brevets

(19)

(11) **EP 0 863 437 B1**

(12) **EUROPEAN PATENT SPECIFICATION**

(45) Date of publication and mention
of the grant of the patent:
**19.06.2002 Bulletin 2002/25**

(51) Int Cl.⁷: **G03F 7/16**, H05K 3/00,
B65G 49/04

(21) Application number: **98103638.7**

(22) Date of filing: **02.03.1998**

(54) **A method for forming a resist layer on a circuit base plate**

Verfahren zur Erzeugung einer Resistschicht auf einer Leiterplattenbasisplatte

Méthode de formation d'une couche de réserve sur une plaque de base pour une planche de circuit imprimé

(84) Designated Contracting States:
**BE DE ES FR GB IT LU NL SE**

(30) Priority: **07.03.1997 JP 7062697**
**28.05.1997 JP 15460697**

(43) Date of publication of application:
**09.09.1998 Bulletin 1998/37**

(73) Proprietor: **Sazma Communication Industry Co., Ltd.**
**Kyoto-shi, Kyoto (JP)**

(72) Inventor: **Mukouzono, Yoshinobu**
**Kyoto-shi, Kyoto (JP)**

(74) Representative:
**TER MEER STEINMEISTER & PARTNER GbR**
**Artur-Ladebeck-Strasse 51**
**33617 Bielefeld (DE)**

(56) References cited:
**US-A- 4 745 004        US-A- 5 334 246**
**US-A- 5 578 410**

- **PATENT ABSTRACTS OF JAPAN vol. 8, no. 166 (M-314), 2 August 1984 & JP 59 063279 A (MITSUBISHI DENKI KK)**
- **PATENT ABSTRACTS OF JAPAN vol. 12, no. 148 (C-493), 7 May 1988 & JP 62 263982 A (FUJITSU LTD.)**
- **PATENT ABSTRACTS OF JAPAN vol. 17, no. 97 (E-1326), 25 February 1993 & JP 04 288892 A (TOPPAN PRINTING CO LTD)**

## Description

Field of the Invention

The present invention relates to a resist layer forming system for forming a layer on a circuit base plate, and in particular relates to a resist layer forming system for forming a layer on a circuit base plate automatically, the thickness of which is thinner than 0.1mm, wherein the thickness of the layer is more uniform.

Prior Arts

Method and an apparatus for transporting circuits and other work units being processed is already known from document US-A-4,745,004, which represents the closest state of the art. The work units, for example, the circuit base plates, are moved along a path extending past the stations to successive position along the path opposite the station, respectively. At each position the work units are extended and retracted into and from the respective station for processing of the work therein. This apparatus is equiped with reck-like holders for holding the boards to be processed vertically, and the boards are moved downwardly and upwardly, respectively, to provide a dipping motion by which the boards are coated by a liquid.

A course for manufacturing circuit-formed plates includes a process for forming a resist-layer on the electrode layer which is formed on an insulating circuit base plate. It is demanded that the more higher the density of a plate in integration is, the more uniform the thickness of resist-layer is. Recently a circuit has a cubic structure, which has a multiple of layers of circuits. It is further demanded that the thickness of a plate is thinner in order that the total of the thickness's of the cubic structure is thin. An insulation base plate is made of glass, epoxy-resin, or other materials. Epoxy-resin is preferable in respect that it is thinner, but it is mechanically strong.

On the other hand, it is demanded that a method for manufacturing circuit plates is appropriate for mass-production. There is known an art for automatically mass-producing circuit plates, wherein each of base plates is dipped into resist-liquid with the plate being hanged by each of hanging devices which are conveyed on a circulation way. Such a known art includes many gripping devices which are provided with a circulating chain wherein the upper portion of each of the circuit plates is gripped by each of the gripping devices. Such a known system is like to the system for automatically developing photographic films. In other words, it is known that the portion of a endless chain on the circulation way moves in the downward direction wherein respective films or respective insulation base plates which are gripped by the respective gripping devices, which are respectively provided with the endless chain, are respectively dipped into resist-liquid or developing liquid.

It is further known that uniformity of the thickness of a layer of resist-liquid depends on the upward and downward velocity of a base plate, dilution of liquid, temperature of liquid, but it is not known that uniformity of the thickness of a layer is extremely lowered when the above mentioned dipping method is applied for a thinner plate like a film. A film having its thin thickness such as 0.06 mm, which is made of epoxy-resin, appears as if it is a floppy film. Such a floppy film, which is suspended by a hanging device, gains complex frequencies on the mechanical system having a conveying chain, and strongly swings with turbulence being strongly generated on the surface of the plate, while the resist-liquid irregularly flows in the all directions different from the gravitational direction on the surface of the plate, thereby the uniformity of the resist-layer is lost.

It is desirable that the thickness of a layer of resist-liquid is thinner with the thickness of the thinner layer being further uniform.

On the other hand, there is one more problem particularly referring to such thickness of a thinner layer of the lower end portion of the plate. A manufacturing process for manufacturing electronic plates includes a process for applying liquid such as photosensitive resist-liquid to base plates with the respective thin layers formed on the surface of the plates. It is desirable that costs of such manufacturing process is made extremely lower in respect of yield efficiency. It is further desirable that the plates have higher density in integration.

The thin layers of plates need further precise uniformity in thickness to meet such desires. Such uniformity needs to be still kept after drying the plates. After being dipped into resist-liquid, a base plate leaves resist-liquid with an appropriate velocity on a vertical plane. There is known a mathematical equation of relation of thickness of the thin layer of a plate to upward velocity of the plate:

$$h = h_o (1 - \rho \, gh_o^{2/3} \, \eta \, v),$$

$$h_o = 0.94 \cdot (\eta \, v)^{2/3}/(\rho \, g)^{1/2} \gamma^{1/6},$$

where

v: upward directional velocity
$\eta$: viscosity of liquid
$\rho$: density of liquid
g: gravitational acceleration
$\gamma$: surface tension

However, there is not known any equation of relation of thickness of the lower end portion of a plate to upward velocity of the plate, wherein the lower end cuts the surface of the resist-liquid when it leaves the resist-liquid.

The layer of the cutting-end-portion, which is identical with the lower end portion of the base plate, is formed thicker in thickness than the layer of the medium portion of the plate. The thickness of the layer of the cutting-end-portion is not independent of the average of the thickness of the layer and the uniformity of the thickness. The inventor's experiment teaches that the thinner the layer of the cutting-end-portion is, the more uniform the thickness of the whole layer. An art, in which such relation is considered, is disclosed by Japan Patent Application Disclosure (Laid-open) No.H8-51268. According to such known art, the lower end line of a base plate inclines against the surface of resist-liquid. Such inclining lower end facilitates to cut the liquid. Such liquid-cutting phenomenon is followed by a running of one meniscus which is formed between the surface of the liquid and the lower end portion. Such.meniscus, which fastly runs from the one end of the lower end portion to the other end of the lower end portion, pulls back the liquid which attaches to the lower end portion of the base plate. High speed of such running to shorten the time of the liquid-cutting makes the efficiency higher.

There is still remaining a problem: the thickness of the end portion of the lower end portion where the running meniscus reaches is thicker than the lower portion other than the end portion. Such thicker portion causes some troubles in the following processes. The resist-liquid of thicker portions, which are not enough in drying, attaches to the film in the process of applying light, thereby the tightness of the film to the base plate is insufficient. Such insufficiency causes unclear copy of the electronic circuit pattern. A part of the resist-material of a thicker portion remains on the base plate without the material perfectly stripped in the process of stripping. Such remaining causes another remaining of a part of the copper layer which is washed away. Such another remaining further causes an outbreak of clearance between plates in the following process of plate-piling. Such clearance leads to produce inferior goods.

Such described aspects referring to thickness of a thin layer teach the inventor that it is still further desirable that a plate silently ascends, and the end portion of the plate more silently ascends with the most appropriate velocity given while it cuts the surface of resist liquid.

Summary of the Invention

An object of the present invention is to provide a method for forming a resist layer on a circuit base plate wherein the thickness of the layer of the thinner plate is more uniform.

Another object of the present invention is to provide a method for forming a resist layer on a circuit base plate wherein the thickness of the layer of the thinner plate is more uniform, and the automatically conveying process is more simple after and before the dipping process.

A further object of the present invention is to provide a system for forming a resist layer on a circuit base plate wherein the thickness of the layer of the thinner plate is more uniform, and which is more cheaply manufactured.

A still further object of the present invention is to provide a method of forming a thin layer on an electronic circuit plate wherein the resist-layer of the lower end portion is substantially zero micron meter in thickness.

A still another objects are particularly described through embodiments of the invention.

A still further object of the present invention is to provide a system for forming a resist layer on a circuit base plate wherein the lower end portion of a plate silently asends with an appropriate velocity given so that the thickness of the layer of the thinner plate is more uniform, and which is more cheaply manufactured.

A system for forming a resist layer on a circuit base plate according to the present invention comprises a conveying system, which includes two series of systems. The two series of systems further include a one way conveyer and a circulation conveyer. The one way conveyer has a base plate conveying means for conveying plates in a one way direction, while the circulation conveyer has a circulating means for circulating gripping means. Each of the gripping means has a pair of gripping devices for gripping a sheet of base plate. The respective base plates are suspended by the respective gripping devices. Both conveyers partially overlap at the dipping process portion. The dipping process portion includes an upward-and-downward driving means for driving the gripping devices in the upward direction and in the downward direction. The one way conveyer includes an after-and-before conveyer portion which is situated before and after the dipping process portion. The after-and-before conveyer portion has a after-and-before driving means for driving no gripping devices but for driving the base plates. The upward-and-downward driving means is mechanically independent from the after-and-before driving means. The movable portion of the upward-and-downward driving means is not mechanically connected with movable portion of the after-and-before driving means. The circulating gripping means suspends the respective base plates on the vertical plane.

The base plates which moves in the upward and downward directions on the dipping process do not receive any vibration of the after-and-before conveying portion because of the independence, thereby the base plates silently moves in both directions. No wave-likely swinging fluid and no fluid of turbulence are not generated on the surface of the plates, thereby the dilution of the resist-liquid is kept constant. The resist-liquid silently flows down on the vertical plane. No irregular flows such as horizontal flows are not generated. No wave-likely varying thickness of the resist-layer are not observed. The surface of the resist-layer is even with the thickness of the layer being kept uniform.

The flow of the base plates toward the dipping portion is continuously formed. Each of the plates are conveyed on the horizontal way of the one way conveying with the lower surface of each of the plates of such continuous flow is supported at a multiple of points. Such conveying system on the horizontal way comprises a multiple of rollers.

Each of the base plates which have been conveyed generally on the horizontal direction is orientated in posture in the vertical direction. The upper portion of the plate, which is oriented to such direction by a posture changing means, is gripped by the gripping devices, and then is conveyed in the upward direction on the vertical plane. The dipping portion has the upward-and-downward driving means as described above. It is desirable that the upward-and-downward driving means is conveyed also in the horizontal direction, wherein the upward-and-downward driving means includes Z-X axes-driving means such as a Z-X axes robot.

The posture changing means is also mechanically independent from the upward-and-downward driving means. In other words, the posture changing means is not connected with the upward-and-downward driving means by any transporting means such as a chain. The motion in the dipping portion, which is independent from the motion of the portion after and before the dipping portion, is silent because there is no pushing and pulling between both mechanical means.

The upward-and-downward driving means has a upward-and-downward moving body, which is guided by a guiding means such as linear bearings. The after-and-before conveying portion includes a horizontally conveying portion, and a base plate receiving-giving means for sending a plate, which is conveyed in the horizontal direction, to the upward-and-downward moving body which receives the plate.

The base plate receiving-giving means has a receiving means, which is identical with a suspending means, by which the base plate is supported with it being suspended. Both surfaces of the suspended plate are generally orientated on the vertical plane by the force of gravity. Especially, both surfaces of the floppy plate is so orientated. Such vertical orientation is known in suspension of a photographic film.

The surface of the desirable upward-and-downward moving body is wave-likely or not evenly formed. Both end portions of the suspending means is supported on the concave portions of the wave-likely uneven surface. The desirable suspending means is formed of a rod-like body. The gripping means has a pair of two gripping bodies, which are provided with the rod-like body at two positions. Each of the gripping bodies has a pair of gripping fingers, which are mutually biased so that it is closed. The ten concave portions are desirably given at ten positions to the one gripping body.

The gripping means are conveyed by the circulation conveyer. The circulation conveyer comprises a go-circulation conveyer and a return-circulation conveyer. The go-way which the go-circulation conveyer forms includes downward-go way, a upward-go way, a giving-and-receiving go-way, a downward dipping process way, an upward dipping process way, and a drying process giving-and-receiving way. The return-way which the return-circulation conveyer forms includes a downward-return way, a upward-return way, a giving-and-receiving return-way, a transferring return-way. The flow of the go-circulation conveyer continuously continues to the flow of the return-circulation conveyer, but the go-circulation conveyer is mechanically divided in relation to the return-circulation conveyer by the giving-and-receiving go-way and the giving-and-receiving return-way. The transferring return-way may be formed of a circulating chain. It is desirable that the upward dipping process way is divided in relation to the drying process giving-and-receiving way.

The supplying-side continuous flow way is formed as it is symmetry with respect to a given mirror surface with the discharging-side continuous flow way. The supplying-side base plate receiving-giving means such as a rotating mechanism is provided between the supplying-side continuous flow way and the upward-and-downward moving body on the dipping process. The discharging-side base plate receiving-giving means, which is also a rotating mechanism, is provided so that it is formed as it is symmetry with respect to the mirror surface with the supplying-side base plate receiving-giving means. It is also desirable that the upward dipping process way is divided in relation to the discharging-side base plate receiving-giving means.

Many drying process carrying bodies are provided with the drying process conveyer. The wave-like uneven surface of a drying process carrying body is of the same shape as the wave-like uneven surface of an upward-and-downward moving body on the dipping process. The drying process carrying bodies are upward and downward movable at a given point on the line on which the drying process carrying bodies are conveyed. One group of the ten gripping devices forwardly advance like a measuring worm by means of a walking beam in cooperation with a drying process carrying body.

A posture transformation means includes holding devices and a rotating devices. Each of the holding devices is formed a multiple sets of inserting rollers. Each of the rotating devices rotates the holding device by 90 degrees in angle at a time. The one posture transformation means situated on the applying part is provided in symmetry with the other posture transformation means situated on the discharging part with respect to the given surface. It is demanded that a base plate to be formed of epoxy-resin has 0.06 mm in thickness. Carried base plates descend and ascend, and advance as they are suspended, and kept plane, thereby they are kept flat.

A base plate, which has been dipped into liquid, and then leaves the liquid, cuts the surface of the liquid. At the time of such liquid surface-cutting by the plate, or at least just before the plate cuts the surface, the velocity of the base plate is lowered. The velocity is extremely lowered in one case, while the plate is at rest in another case. During the velocity is lowered, a meniscus, which is identical with a mono-meniscus, are formed like a bridge between the surface of the liquid and the lower end portion of the base plate. The meniscus runs from the one side to the other side of the lower end portion. The larger the angle between the lower end line of the plate and the surface of the liquid is, the larger the speed of the meniscus is. It is desirable that the angle is smaller. The slow velocity facilitates to inhibit the turbulence of flow on the surface of the lower end portion of the plate. The upward-and-downward moving body, which is independent of the other mechanism, silently ascends.

It is more advantageous that one driving system for transforming the posture of a plate is mechanically independent of another driving system for descending the plate, while one more driving system for ascending the plate is mechanically independent of one more another driving system for transferring the plate. It is further more advantageous that the receiving-giving means is mechanically independent of the ascending-descending means for ascending and descending the upward-and-downward moving body. It is most desirable that the upward-and-downward moving body is substantially independent of all of the other mechanism for conveying or carrying.

The suspending means includes a rod-like body and a gripping means. The rod-like body is desirably cylindrical. The gripping means or the holding devices is eccentricly situated away from the center line of the rod-like body, thereby the gripping means is kept constant in the posture by the force og gravity. The base plate, to which a buoyancy acts, is stable on a vertical plane in the liquid.

On the other hand, the base plate leaves the resist-liquid with a thin resist-layer formed on the surface of the base plate. The resist-layer includes a lower end layer and a medium layer. The medium layer is formed on the medium portion of the base plate between the lower end layer and the upper end of the base plate. The lower end layer cuts the resist-liquid or the surface of the resist-liquid. The layer of the lower end portion of the plate has the thickness that is not thicker than that of the medium layer. The layer of the lower end portion includes thicker portions and thinner portions, the thickness of which are thinner than the thickness of the thicker portions. Each of the thicker portions is situated between one thinner portion and another thinner portion which is next to the thinner portion. The lower end portion has alternative values along the lower end line of the base plate. In other words, the thickness wave-likely values along on a horizontal line.

Such a thin layer is coated during a meniscus slowly or gently runs from one end of the lower end portion to another end thereof. The meniscus is formed between the lower end portion of the plate and the surface of the resist-liquid. It is outbroken by gravitation and surface tension. The form of the meniscus is generally uniform during the time when the meniscus runs, and the velocity of the meniscus is generally constant. Because of the constant form and velocity, the amount of liquid which is pulled to the surface of the resist-liquid by the surface tension is constant per unit time. However, the thickness of the layer of the lower end portion wave-likely values, because the velocity of the single meniscus has a frequency. In other words, the velocity of the meniscus alternatively increases and decreases. The thinner portion of the thin layer of the lower end portion is observed as substantially zero in thickness.

The thin layer in which such coated material dotted line-likely distributes has thicker portions and thin portions. The thickness of the thin portion is thinner than the average thickness which is generally identical with the thickness of the above mentioned medium portion. A plate, the layer of the lower end portion of which is formed thinner, better fits to a film for forming a circuit pattern, and has high resolution. The above mentioned wave-like distribution gives higher resolution to the circuit pattern.

The upward velocity of a plate is lowered on the process of cutting the resist-liquid by the cutting-liquid portion of said base plate. The liquid cutting portion corresponds or is identical to the lowest portion of the plate. It is desirable that the velocity on the process of cutting is higher than one hundredth of the maximum velocity on the process of moving in the upward direction, while it is lower than one tenth of the maximum velocity. Such lowered velocity lengthens the time during cutting the liquid. Such lowered velocity presents the flow of the liquid from the upward directionally pressing, the flow downward moving on the surface of the plate. Such prevention facilitates the layer to be thinner.

The coefficiency of viscosity of said resist-liquid is lower at 25 degrees Celsius than 40 cps, and the average of the velocity before entering into the process of the cutting is higher than 10 mm a second. The average is lower than 70 mm a second, while the velocity on the process of the cutting is higher than 0.1 mm a second, and the velocity on the process of the cutting is lower than 1.0 mm a second. the time during the process of cutting is not shorter than the time during the running of the meniscus-forming portion from the one end to the other end.

Such a slow velocity of a meniscus facilitates to cut the resist-liquid attaching to a plate. the liquid is sufficiently pulled into the liquid on the side of a liquid tank without it remaining on the side of the plate. This results in high yield efficiency in manufacturing. The velocity is slow only on the process of cutting, thereby it does not lower the manufacturing efficiency.

According to the present invention, an upward-and-downward moving body which is independent of the driving mechanism situating after and before the upward-and-downward moving body silently ascends, thereby a moving plate does not tremble or vibrate. In the rusult, the thickness of the lower end portion of the plate is uniform. Further, because of no vibration just before the lower end line of the plate leaves or cuts the surface of the liquid, the running of a meniscus is stable, thereby the thickness is more uniform. The surface of the lower end portion of the resist-layer is not wave-likely formed, but is even, and the average of the thickness is thinner.

The present invention has a further advantage that the lower end portion of a base plate has a layer which is not thicker than the thickness of the medium portion thereof.Such thinner thickness of the lower end portion of a plate is more uniformly formed by silent ascension of the plate and having the most appropriate velocity thereof.

Brief Description of the Drawings

Fig. 1 conceptually shows a front sectional view conveying system in a system for forming a resist layer on a circuit base plate according to the present invention.

Fig.2 shows a front view of an outward appearance of a system of Fig. 1

Fig.3 shows a horizontal view of a conveying system of a base plate supplying portion A.

Fig.4 shows a front view of a supplying-side posture transforming portion B.

Fig.5 shows a side view of Fig.4.

Fig.6 shows a front view of the portion of Fig.4.

Fig.7 shows a horizontal view of a supplying-side ascending portion C, a downward go-passage portion L, and an upward go-passage portion M.

Fig. 8 shows a front view of Fig.7.

Fig.9 shows a side view of Fig.8.

Fig.10 shows a front view of a suspending means.

Fig.11 shows a side view of the closing state of the portion of Fig.10.

Fig.12 shows a side view of the opening state of the portion of Fig.10.

Fig.13 shows a horizontal view of a dipping process conveying portion E.

Fig.14 shows a front view of Fig.13.

Fig.15 shows a side view of Fig.13.

Fig.16 shows a front view of the portion of Fig. 14.

Fig.17 shows a horizontal view of a supplying-side base plate receiving-and-giving portion D.

Fig.18 shows a front view of Fig.17.

Fig.19 shows a side view of Fig.18.

Fig.20 shows a perspective view of a step-by-step advancing mechanism.

Fig.21 shows a front view of a drying process portion F.

Fig.22 shows a front view of a returning portion Q.

Fig.23 conceptually shows a front view of the whole conveying system.

Fig.24 shows a sectional view to show a method for dipping.

Fig.25 (a), (b) and (c) shows three conceptional views for interpretative a liquid cutting process.

Fig.26 (a) and (b) is respective side sectional view of Fig.18 (b) and (c).

Fig.27 (a) and (b) is an enlarged view of a horizontal meniscus of Fig.19 (a) and (b).

Fig.28 is a sectional view of a vertical meniscus.

Fig.29 (a) ,(b), (c), (d), and (e) is a front view showing respective layer thicknesses.

Fig.30 is a sectional view of Fig.29 (c).

Fig.31 (a) and (b) is a side sectional view showing the respective thicknesses of the layers in comparison therewith.

Fig.32 is a side sectional view showing the known thickness.

Detailed Description of the Invention

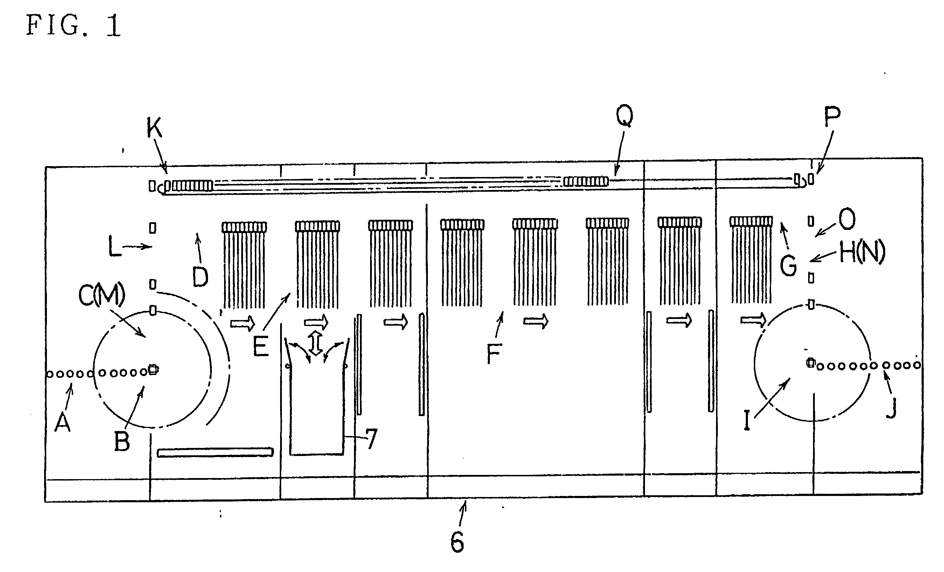

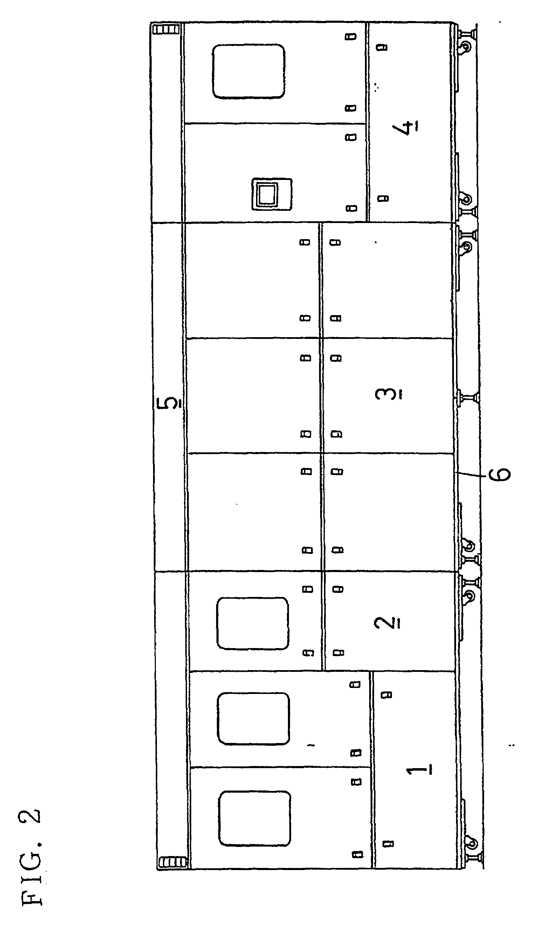

Fig. 1 illustrates an embodiment of a resist layer forming system for forming a layer on a circuit base plate according to the present invention. Fig. 2 shows the casings, inside which the resist layer forming system is positioned.

The resist-layer forming system has a base plate conveying system, which includes a base plate supplying portion A, a supplying-side posture transforming portion B, a supplying-side ascending portion C, a supplying-side base plate receiving-and-giving portion D, a dipping process conveying portion E which is included in a dipping portion, a drying process portion F, a discharging-side base plate receiving-and-giving portion G, a discharging-side base plate descending portion H, a discharging-side posture transforming portion I, and a base plate discharging portion J.

A circulation conveying means includes a receiving-and-giving go-passage portion K, a downward go-passage portion L, an upward go-passage portion M which is commonly identical with the supplying-side ascending portion C, a common dipping process conveying portion E, a common drying process portion F, a downward return-passage portion N which is identical with the discharging-side base plate descending portion, an upward return passage portion O, a receiving-and-giving return-passage portion P, and returning portion Q.

As shown in Fig. 2, the casing includes a supplying-side casing 1 which corresponds to base plate supplying portion A, a dipping-side casing 2 which corresponds to dipping process conveying portion E, a drying-side casing 3 which corresponds to common drying process portion F, a discharging-side casing which corresponds to base plate discharging portion J, and returning-side casing 5 which corresponds to returning portion Q.

These casings dress and cover the fully automatic system placed on a base floor 6. Base floor 6 fixedly floats over the ground. A resist liquid tank 7 is provided with the dipping portion. Resist liquid tank 7 which collects the resist liquid is of an overflow type. Each of the portions is explained in what follows.

(base plate supplying portion A)

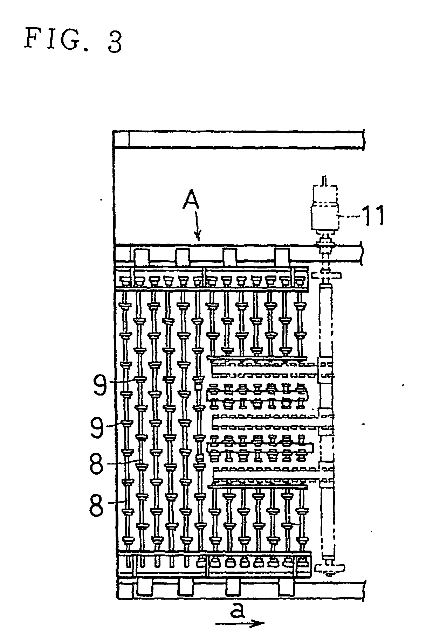

As shown in Fig.3, the base plate supplying portion A which forms the base plate supplying-conveying system includes rotating shafts 8 which are rotatably located on a surface. Rotating shafts 8 has the respective axis lines which are perpendicular to the conveying direction. The respective axis lines of rotating shafts 8 are mutually parallel with each other. Each of rotating shafts 8 has many rubber-made rollers 9 at even intervals. All the rotating shafts 8 circumscribe with the given even plane to form the conveying surface of the supplying-side portion.

A gear for transmitting power is mounted on the one end of each of rotating shafts 8. The gears respectively engage with bevel gears (not shown), each of which is synchronizedly driven by a common driving power source 11. All the rollers having the same radiuses rotate with a common peripheral velocity.

Each base plate (not shown) is supported on a multiple of points included in the conveying even plane by the many rollers. Both the inside surface and the outside surface are formed to respectively be even planes. Accordingly, each base plate advances and is conveyed on the generally horizontal plane without any movement of rotation. The conveying plane can receive the size of a base plate, the width of which is longest. A multiple of base plates continuously in a series flows in base plate supplying portion A.

(supplying-side posture transforming portion B)

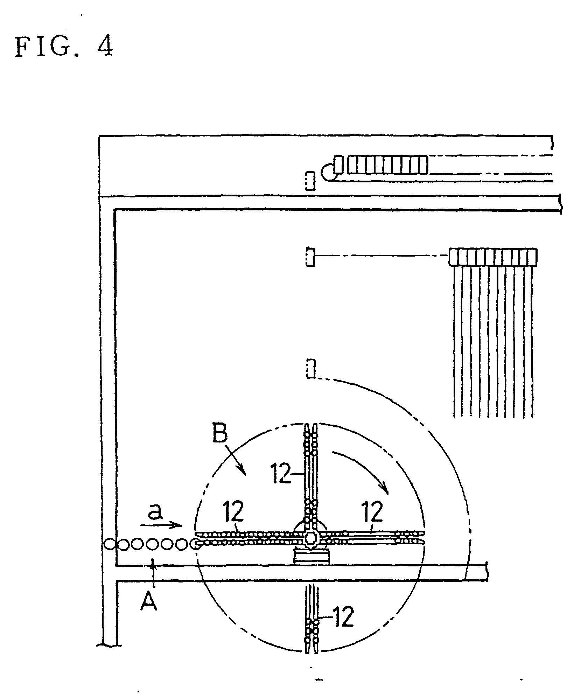

Fig.4 illustrates the supplying-side posture transforming portion B. Supplying-side posture transforming portion B which is formed to be continuous with base plate supplying portion A forms the conveying system which transforms the posture by 90 degrees in angle. Supplying-side posture transforming portion B includes three sets, each of which has four pairs of gripping means 12.

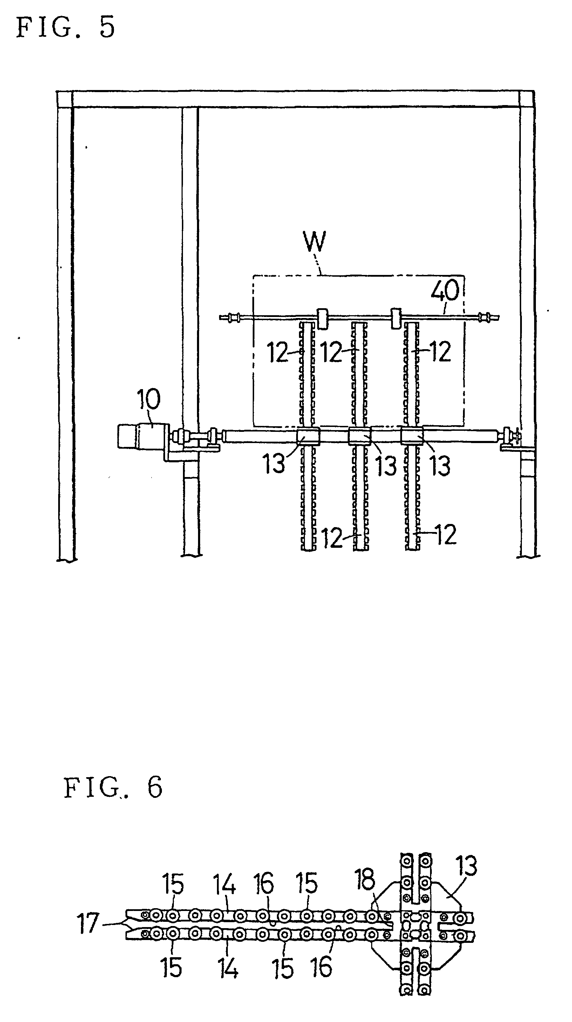

Each pair of four pairs of gripping means 12 is connected with a phase shifting rotating shaft 13 so that it is oriented in each radial direction. Phase shifting rotating shaft 13 is rotated, as shown in Fig.6, in one way direction at a unit of interval of 90 degrees in angle by a motor 10 (shown in Fig.5). The unit of 90 degrees rotation is controlled by a micro-photo-sensor (not shown).

As shown in Fig.6, each gripping means 12 includes two bodies of roller supporting arms 14 and a multiple of gripping rollers 15. The two bodies of roller supporting arms 14 have mutually facing surfaces 16 which are generally parallel with each other.

Gripping rollers 15 are respectively mounted on roller supporting arms 14 so that the respective gripping rollers 15 slightly project from the respective facing surfaces against the other part. Gripping rollers are mounted on roller supporting arms 14 so that they are arranged at regular intervals with lining in the respective radial directions.

Facing gripping rollers of the one pair are located at the positions which are the same in the respective radial directions. The shortest distance between the gripping rollers 15 which face with each other at the same radial directional portions is longer than the thickness of the thinnest base plates. For example, it is no longer than 0.06mm. All the gripping rollers 15 are free to spin on the respective axes. Four pairs of gripping means 12 are mounted on phase shifting rotating shaft 13 at the phase-difference of 90 degrees of intervals.

8 bodies of roller supporting arms 14 have the respective distances which are mutually equal to one another. Two bodies of mutually facing roller supporting arms 14 have the respective facing surfaces are taperedly formed on the respective outside end portions thereof. Such tapered surfaces 17 lead base plates which are conveyed on base plate supplying portion A to be inserted into gripping means 12.

As shown in Fig.5, there are provided three pairs of four bodies of gripping means 12, roller supporting arms 14 of which are located at the regular phases. That is, the three spaces between the respectively facing roller supporting arms 14 are located on a plane. One base plate is inserted into the spaces between each of the three pairs of respective gripping rollers 15 of roller supporting arms 14. A stopper 18 (Fig.6) is formed at the central portion between roller supporting arms 14.

The dimension of a standing-up circuit base plate W is illustrated in Fig.5 for an example. The size of the circuit base plate W is 720 mm in the longitudinal length and 530 mm in the width. The thickness of the circuit base plate W is no thinner than 0.06 mm for an example, thereby it is floppy, and is facilitated to wave-likely curve unless it is physically restricted. Epoxy resin is desirably available for materials of a circuit base plate W which is necessary to insulate.

A circuit base plate W, which moves on the horizontal plane which is formed in base plate supplying portion A, is inserted into gripping means 12 to attach to stopper 18 to stop. Phase shifting rotating shaft 13, which is driven by motor 10, rotates by 90 degrees in angle in the clockwise direction. The horizontal posture of the circuit base plate W is transformed to be the vertical posture, which may be generally vertical. The three pairs of gripping means 12 are adaptable for various kinds of widths of circuit base plates W. A circuit base plate W is supported by three pairs of gripping means 12 with being rectangularly formed and preserving its rigidity even when it stands up.

(supplying-side ascending portion C)

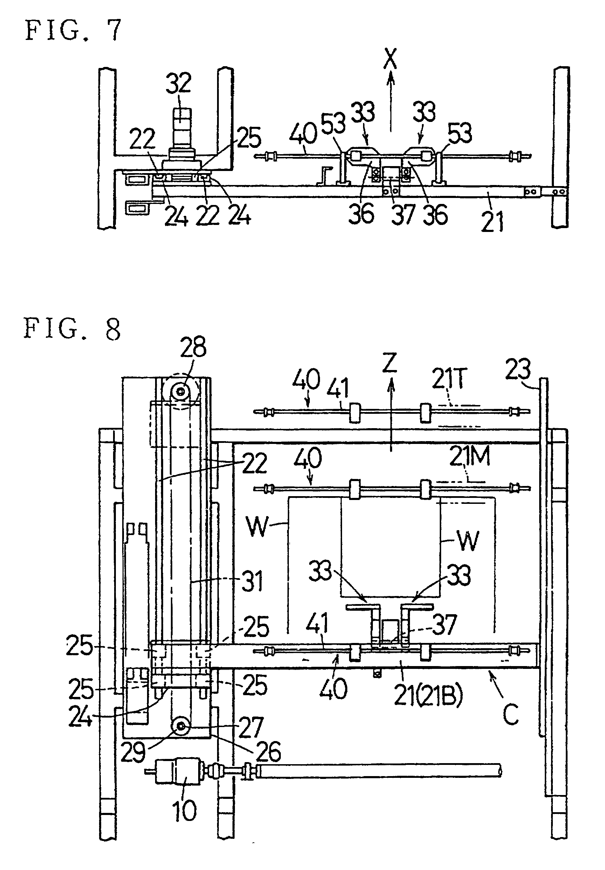

Figs. 7-9 illustrates the supplying-side ascending portion C for ascending a circuit base plate W to a certain height position which stands up in supplying-side posture transforming portion B. Supplying-side ascending portion C includes an ascending-descending base 21 which ascends and descends. As shown in Fig.8, an ascending-descending base 21, which extrudes in the horizontal direction, moves with both the end portions thereof being guided by a main guiding rail 22 and a subguiding rail 23.

Main guiding rail 22 includes two ways of guiding bodies which extrude in the respective vertical directions, and each of which is rectangular in form on a sectional view. An embracing body 24, which embraces main guiding rail 22 as shown in Figs.7-8, is fixed with ascending-descending base 21 on the lower surface of ascending-descending base 21 so that it extrudes in the horizontal direction. Two embracing portions 25 are formed at the two positions of embracing body 24, the height of the one of which is equal to the height of the other thereof.

The two positions of embracing portions 25 forms one pair. Another pair of embracing portions 25 is fixed with ascending-descending base 21 at the position different in height from the position of the one pair. As shown in Fig.8, a driving rotating shaft for ascending-descending-use driving shaft 27 is rotatably mounted on an appropriate supporting base 26. A slave-side pulley 28 is rotatably and fixedly provided at a vertically higher position.

An ends having timing belt is provided between a master-side pulley 29 and slave-side pulley, the axis line of master-side pulley 29 being identical with the axis line of ascending-descending-use driving shaft 27. Both ends portions of timing belt 31 are fixed with ascending-descending base 21 or the portion which is one with ascending-descending base 21. Ascending-descending-use driving shaft 27 is rotatbly driven by a first servomotor for ascending-descending use 32 as shown in Fig.7.

Ascending-descending base 21 descends and ascends in response to the reciprocatiing rotation of first servomotor for ascending-descending use 32. The upper limit position towards which ascending-descending base 21 ascends and the lower limit position towards which ascending-descending base 21 descends are respectively changed by controlling the angle of rotation of the first servomotor for ascending-descending use 32. Supplying-side ascending portion C is made as a robot by means that the whole system is controlled so that angles of rotation of first servomotor for ascending-descending use 32 are detected in one-to-one correspondence in response to respective positions in height of ascending-descending base 21 with the controller of the whole system memorizing the angles.

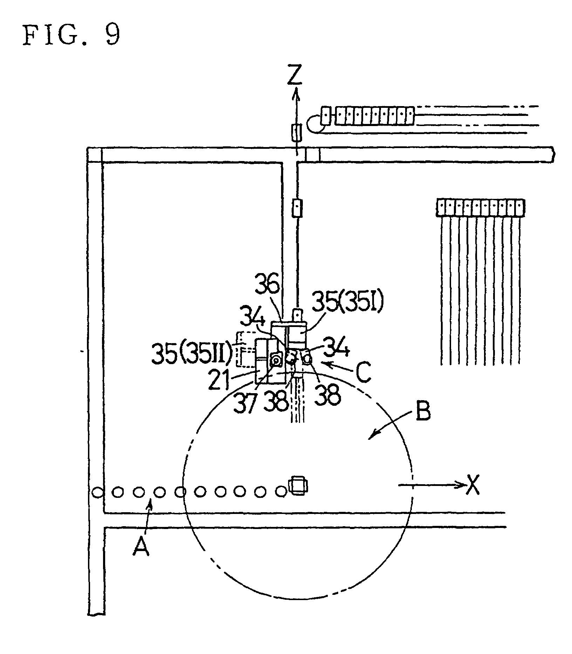

A gripping means driving mechanisms 33 is provided with the generally central portion of ascending-descending base 21. Gripping means driving mechanism 33 drives a suspending means, which is detailedly described hereinafter. The two gripping means driving mechanisms 33 are symmetrically provided as the pair with respect to the center between the left and right sides. As shown in Fig. 9, one of the pairs of gripping means driving mechanisms 33 has two bodies of closing-opening fingers 34.

Closing-opening fingers 34 are closed and opened by an actuator (not shown) which is built in an air-chucking casing 35. Air-chucking casing 35 is mounted on a rotating arms 36. Rotating arms 36, as shown in Figs.7-9, are mounted on ascending-descending base 21 through an axle for swinging 37.

Each of the two bodies of rotating arms 36 owns its axle for swinging 37 in common. The axis line of one axle for swinging 37 orients in the horizontal direction, which is parallel to the direction in which ascending-descending base 21 extrudes. A coordinates Z-X are located in Fig.9. The Z-axis is oriented in the vertical direction, while the X-axis is oriented in the conveying direction in base plate supplying portion A. Closing-opening fingers 34 closingly-openingly moves on the Z-X plane. Gripping means driving mechanisms 33 rotatably swings on the Z-X plane around the axis line of axle for swinging 37.

The swinging angle between which gripping means driving mechanisms 33 is generally equal to 90 degrees. As shown in Fig.9, air-chucking casing 35 swings between the actuating position 35I shown by a real line and the actuating position 35 II shown by a dotted line. The two actuating end portions of the two bodies of closing-opening fingers 34 are respectively provided with the two of a pair of rolling fingers 38.

The pair of rolling fingers 38 is made of a pair of rollers. As shown in Fig.8, ascending-descending base 21 ascends and descends between three positions, and is able to be at rest at the three positions. The three positions are respectively identical with the upper position 21T, the middle position 21M, and the lower position 21B. The meaning of these positions is explained later.

(suspending means 40)

The suspending means 40 circulates a closed loop of a circulatively conveying way. The circulatively conveying way includes two ascending-descending ways, and a before-and-behind way which is continuous to the ways before and behind the each of the two ascending-descending ways. The before-and-behind way is mechanically intermittent and intermittently continuous to the one of the ascending-descending ways. Suspending means 40 includes a rod-like body having a rotational axis line and a multiple of gripping devices mounted on the rod-like body. If the rod-like body is located on a horizontal plane, the center of gravity of the rod-like body is positioned under the rotational axis line. One of the gripping devices has a pair of gripping fingers opens and closes so that it grips the upper portions of a circuit base plate.

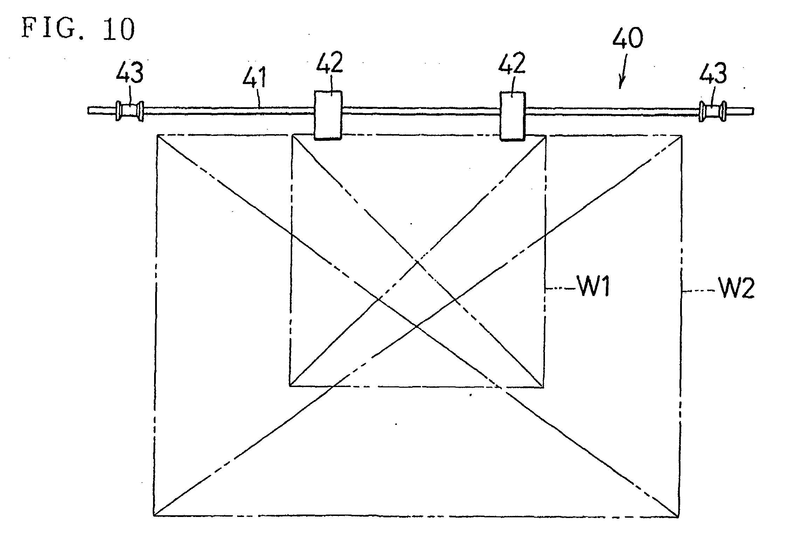

Suspending means 40 is circulatively conveyed by the circulatively conveying means as described below. A work W, such as a circuit base plate, is conveyed with being gripped by suspending means 40 which is on a portion of the circulating conveyer way formed by the circulative conveying means. As shown in Fig. 10, Suspending means 40 includes suspending-use rod-like body 41, two bodies of suspending-use gripping means 42, and both sides of wheels 43. Wheels 43 enable suspending means 40 to swing in order that the vertical posture of the work is self-controlled.

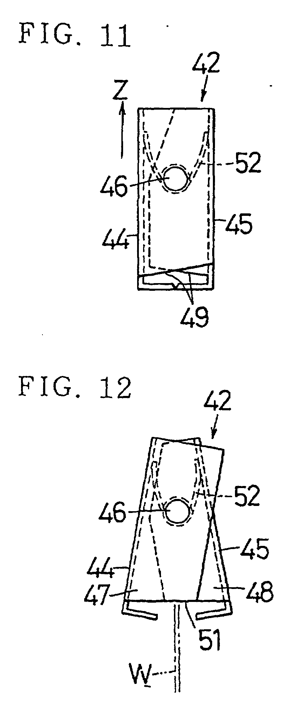

Suspending-use rod-like body 41 is formed of a cylindrical rod. The two bodies of suspending-use gripping means 42 and the two bodies of wheels are respectively symmetrically located in relation to each other, and fixed with suspending-use rod-like body 41. Metal-made clips on the market may be generally utilized for suspending-use gripping means 42. As shown Figs.11-12, suspending-use gripping means 42 has two bodies of holding nails 44, 45.

The two bodies of holding nails 44, 45 are freely opened and closed by gripping-use opening-closing axle 46, which is identical with suspending-use rod-like body 41. Holding nails 44 and 45 have side plates 47, 48 which have the respective surfaces perpendicular to the axis line of gripping-use opening-closing axle 46. The bottom portions of side plates 47, 48 form the respective crossing lines 49 at the gripping position shown in Fig.11, while the bottom portions of side plates 47, 48 form the respective horizontal straight lines 51 at the position of the cancellation of the gripping.

As shown in Fig. 12, when holding nails 44 and 45 close after the circuit base plate W ascends in the vertical direction identical with Z-axis direction and collide with the lower end(s) of side plates forming the straight line(s), the circuit base plate W is guided the crossing lines 49, and inserted at the predecided position of suspending-use gripping means 42 which generally corresponds to the middle position thereof.

Holding nails 44 and 45 are always biased in the closing direction in which they are closed with the force of the winded bias means 52. As shown in Fig.10, suspending means 40 is designed so that it is able to hold a circuit base plate W1 of the maximum size in width and circuit base plate W2 of the minimum size in width. As shown in Fig. 7, suspending-use rod-like body 41 of suspending means 40 is placed at the two positions on the placing concave surface (not shown) formed as the upper surface of a placing bed 53 which protrudes in the horizontal direction (equal to the X-axis) from ascending-descending base 21. Suspending-use rod-like body 41 is able to ascend with respect to ascending-descending base 21 in the vertical direction identical with the Z-axis during the time when gripping means driving mechanism 33 retires.

(dipping process conveying portion E)

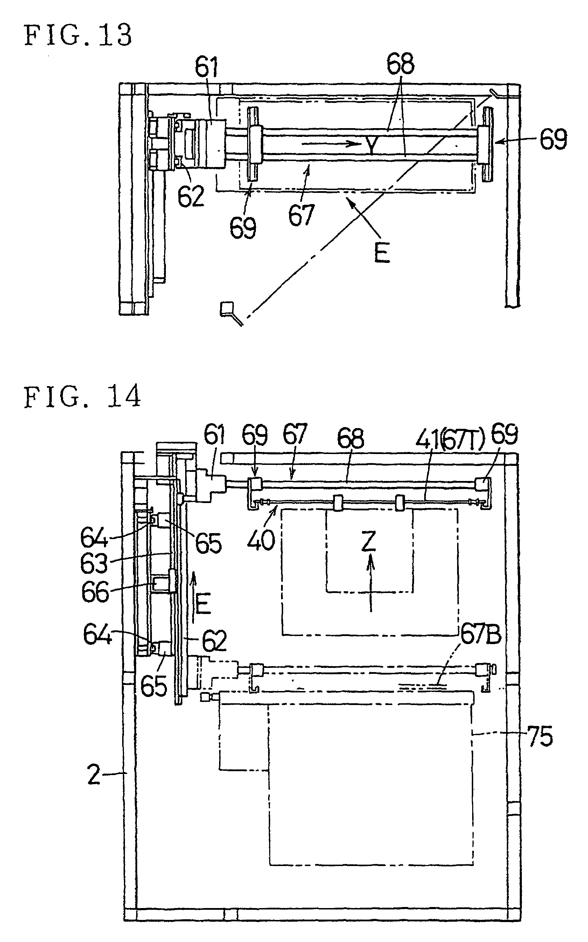

Figs.13-15 illustrates the dipping process conveying portion E. The X-axis of Fig.14 is identical with the line perpendicular to the paper. A ascending-descending portion-in-dipping portion 61 is ascendable and descendable provided with an ascending-descending-use rail-in-dipping portion 62. For ascending-descending portion-in-dipping portion 61 may be applied an ascending-descending mechanism same as the ascending-descending mechanism shown in Fig.8, which has the timing belt rotatably driven by the driving pulley for ascending and descending ascending-descending base 21. The explanation of the detail thereof is omitted.

Ascending-descending-use rail-in-dipping portion 62 is fixedly mounted on X-axis directionally reciprocative body-in-dipping portion 63. Two ways of X-axis directionally, guiding rails-in-dipping portion 64 is fixedly mounted on the dipping-side casing 2. Embracing devices 65 are provided at two positions with ascending-descending-use rail-in-dipping portion 62. Embracing devices 65 embrace X-axis directionally guiding rails-in-dipping portion 64. As shown in Fig.14-15, a rodless cylinder 66 is mounted on dipping-side casing 22. As shown in Fig.14-15, a rodless cylinder 66 is mounted on dipping-side casing 22.

The movable side portion of rodless cylinder 66 is connected with X-axis directionally reciprocative body-in-dipping portion 63. As shown in Fig.13-14, a conveying means-in-dipping portion 67 is fixedly mounted on ascending-descending portion-in-dipping portion 61. Conveying means-in-dipping portion 67 includes conveying use structural portion 68 and a hooking devices 69.

Conveying-use structural portions 68 are made of two rod-like bodies extruding parallel with each other in the Y-axis direction. The Y-axis is perpendicular to the X-Z plane. The one end portion of conveying-use structural portions 68 is inserted into and strongly fixed with ascending-descending portion-in-dipping portion 61. Hooking devices 69 are fixed at two positions spaced apart in the Y-axis direction with conveying-use structural portions 68. Hooking devices 69 are located symmetrical each other.

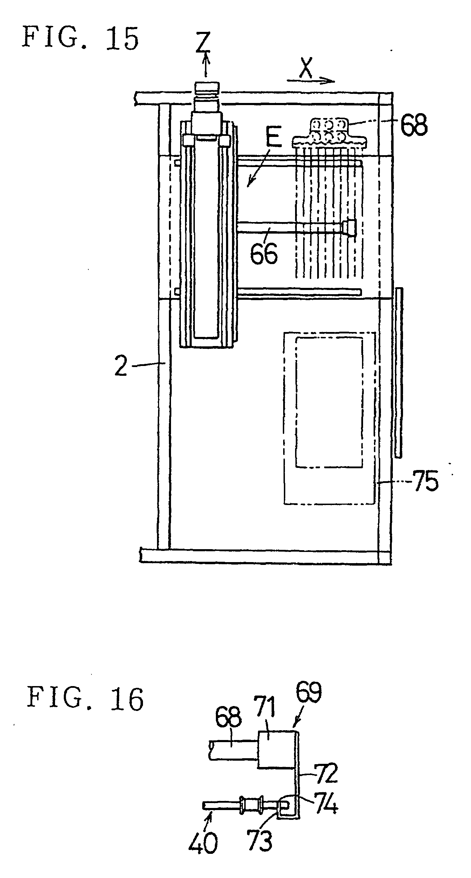

As shown in Fig. 16, each of hooking devices 69 includes a hooking body 71 and an wave forming plate 72. A standing-up portion 73 is formed as the lower portion of wave forming plate 72. The facing standing-up portions 73 are respectively bended and stands up with respect to the vertical main bodies of wave forming plate 72. The upper surface of standing-up portion 73 is wave-surface-likely as the convexly-and-concavely formed surface 74. Convexly-and-concavely formed surface 74 has ten concave portions. The ten portions are arranged in the X-axis direction which is perpendicular to the paper referring to Fig.16. The respective portions of both end sides of suspending-use rod-like body 41 are placed on the respective ten concave surfaces.

As shown in Fig.14, suspending means 40 ascends and descends between the top position 67T shown by a real line and the bottom position 67B shown by a dotted line, and is at rest at the top position 67T and the bottom position 67B. Conveying means-in-dipping portion 67 can reciprocates at a given interval in the X-axis direction.

A resist liquid tank 75, as shown in Fig.14-15 placed on the floor of dipping-side casing 2. The upper portion of resist liquid tank 75 is opened. The resist liquid circulates through resist liquid tank 75 where the resist liquid flows on a overflow system therein. The respective densities of the ingredients of the resist liquid is controlled by supplement thereof with the temperature also being controlled. The flow of the resist liquid is so regularly circulated that no vibration of the wave surface occurs.

(supplying-side base plate receiving-and-giving portion D)

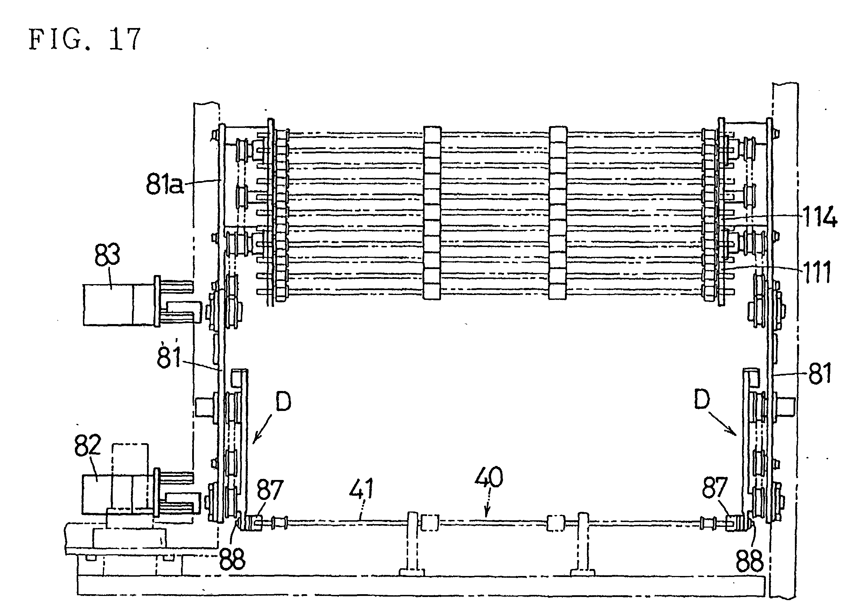

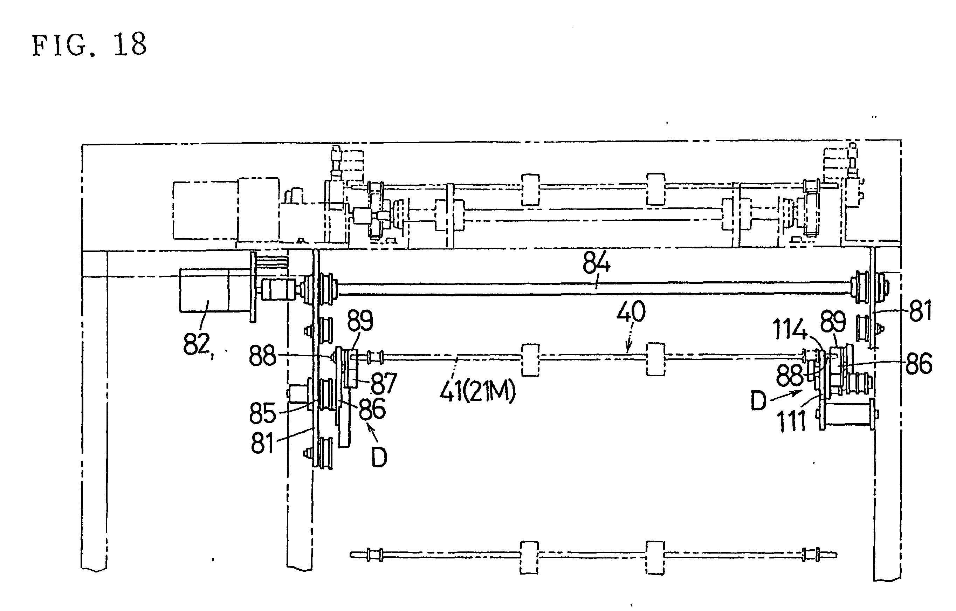

Suspending means 40 at the middle position 21M as shown in Fig.8 is transmitted to the upper position 67T as shown in Fig.14. Figs.17-19 illustrate the supplying-side base plate receiving-and-giving portion D for such transmission. The supplying-side base plate receiving-and-giving portion D includes a step-by-step advancing means as described later. A main body plates are fixedly mounted on the two mutually facing walls of dipping-side casing 2.

Two servomotors are mounted on main body plates 81. As appearing in Fig. 17, these two servomotors correspond to a transmitting-use servomotor 82 and a step-by-step advancing-use servomotor 83. An output power shaft 84 is provided with transmitting-use servomotor 82.

One end portion of output power shaft 84 is rotatably supported by one of main body plates 81. Both sides of transmitting-use axles 85 are rotatably supported by both sides of main body plates 81. Both sides of transmitting-use rotating arms 86 are respectively mounted in a body on both sides of transmitting-use axles 85. A spinning-on-its-axis and suspending bodies 87 are mounted on the respective free end portions of both sides of transmitting-use rotating arms 86.

The center of gravity of each of spinning-on-its-axis and suspending bodies 87 is under a spinning axis 88. Spinning-on-its-axis and suspending bodies 87 are oriented at all times in the vertical direction. The top surface of each of spinning-on-its-axis and suspending bodies 87 is formed as a transmitting-use concave 89. Suspending-use rod-like body 41 of suspending means 40 is placed on transmitting-use concave 89. A timing belt circles through one pulley having an axis coaxial with output power shaft 84 and another pulley having an axis coaxial with transmitting-use axles 85.

Transmitting-use rotating arms 86 intermittently make one revolution by means of transmitting-use servomotor 82. Suspending means 40 at the middle position 21M is scooped by spinning-on-its-axis and suspending bodies 87 during transmitting-use rotating arms 86 are making one revolution, and rotates at the interval of 120 degrees in angle to be placed on wave forming plates 72 of conveying-use structural portions 68 of conveying means-in-dipping portion 67.

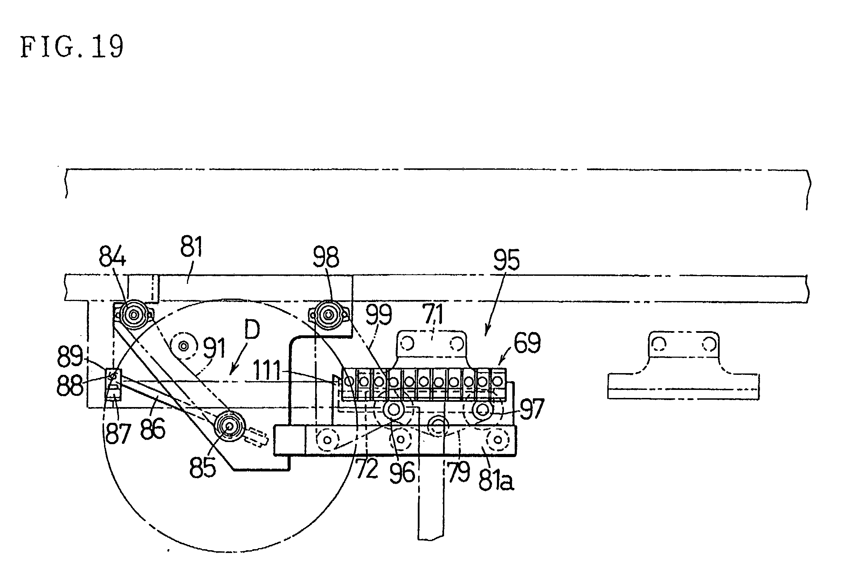

Fig.19 illustrates the step-by-step advancing 95. One of main body plates 81 has extruding front portion 81a. A first slave pulley 96 and a second salve pulley 97 are rotatbaly mounted on extruding front portion 81a. First slave pulley 96, second salve pulley 97 and a driving pulley 98 which has an axis coaxial with the output axle of step-by-step advancing-use servomotor 83 are interlocked with one another by a step-by-step advancing-use timing belt 99.

Two parallel links (not shown) having the same length are connected with first slave pulley 96 and second salve pulley 97, the parallel links constituting a mechanism of four rotatable joints. A step-by-step advancing plate 111 is rotatably connected with the free end portions of the parallel links. A voluntary position of step-by-step advancing plate 111 circularly moves around an individual center, all the points thereof have respective individual circular movements in parallel.

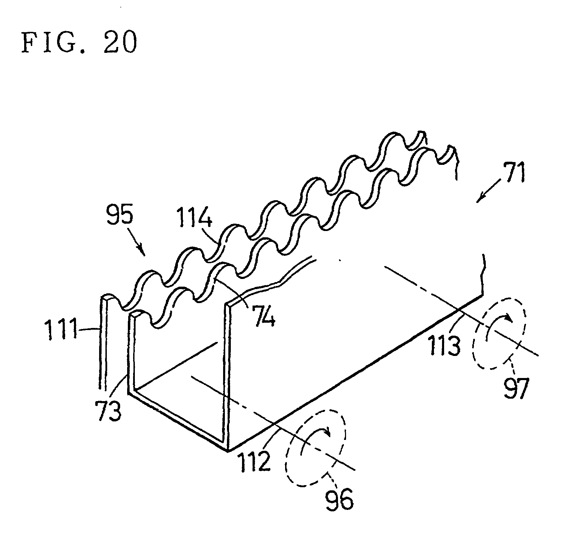

As shown in Fig.20, the driving center lines 112 and 113 of the driving portions for rotating step-by-step advancing plates 121 in parallel are respectively identical with the rotating axis lines of both pullies 96 and 97. As shown in Fig. 20, the top surface of step-by-step advancing plate 111 is formed as a wave-like driving-side step-by-step advancing-use convex-and-concave surfaces 114.

Suspending-use rod-like body 41 of suspending means 40 holding a circuit base plate as a work is placed on the first step of concave surface of convexly-and-concavely formed surface 74 of each of hooking devices 69 after the first rotation of transmitting-use rotating arms 86. Suspending-use rod-like body 41 advances step by step at one concave-and-convex interval to be placed on the second step of concave surfaces while being forced by the bevel surfaces of wave-like driving-side step-by-step advancing-use convex-and-concave surfaces 114 of step-by-step advancing plate 111 which simultaneously make one time of revolution in parallel. Such ten step-by-step movements of hooking devices 69 allow ten bodies of suspending-use rod-like body 41 to be placed on the respective ten concave surfaces.

(drying process portion F)

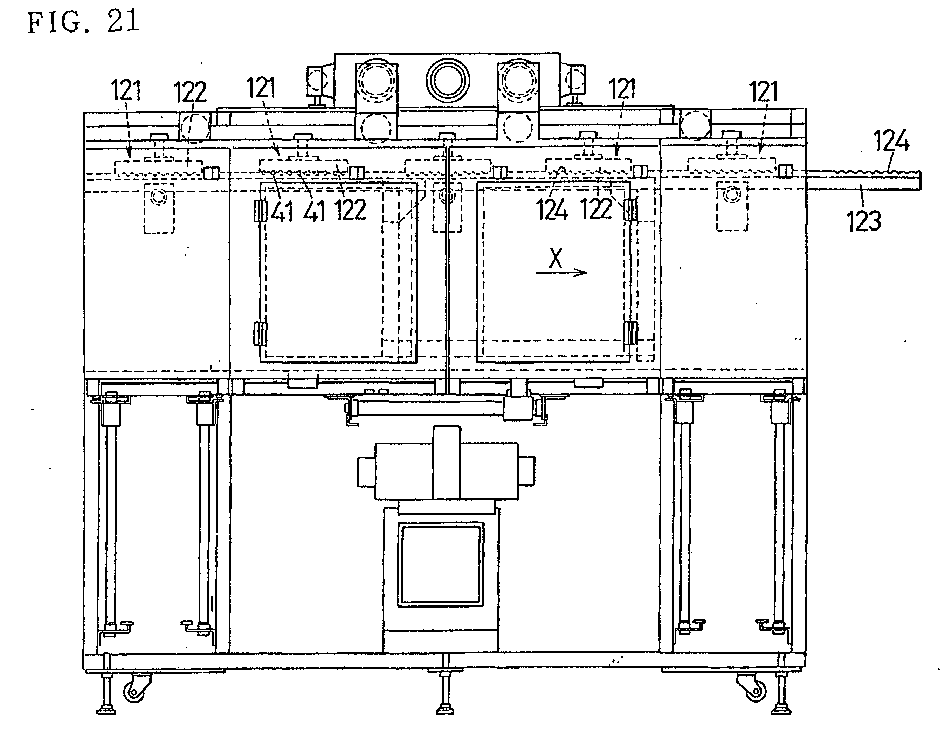

Fig.21 illustrates the conveying means in the drying process portion F. Drying process portion F includes ascending-and-descending bodies in-drying portion 121 which are arranged at five positions in the X-axis direction at even intervals. The two bodies of a pair of two ascending-and-descending bodies in-drying portion 121 are provided on both sides along a X-axis directional line at each of the five positions. The five pairs of ten ascending-and-descending bodies in-drying portion 121 simultaneously ascended and descended in parallel with one another by an common ascending-and-descending-use means, which does not appear in Fig. 21.

Each of ascending-and-descending bodies in-drying portion 121 includes a wave forming plates in-drying portion 122 (which resemble the wave forming plate 72 as shown Fig.20), the top surface of which is formed as a placing-use convex-and-concave surface (which does not appear in Fig.121), the wave-like placing-use convex-and-concave surface facing ten concave portions. A walking beam 123 having a pair of two rows of beams is provided under wave forming plates in-drying portion 122.

Walking beam 123 reciprocates in the X-axis direction by means of a reciprocatively driving means. The interval of the reciprocation is kept constant. The constant is identical. with the interval between the two ascending-and-descending bodies in-drying portion 121 neighboring each other in the before and behind direction (X-axis direction). The top surfaces of walking beam 123 are formed as 5 pairs of holding-use convex-and-concave surfaces 124.

The five pairs of holding-use convex-and-concave surfaces 124 are congruent with one another. The interval between the two of the neighboring holding-use convex-and-concave surfaces 124 is equal to the above described interval. During walking beam 123 moves, all ascending-and-descending bodies in-drying portion 121 are at descending positions. Accordingly, all suspending-use rod-like body 41 of all suspending means 40 are placed on holding-use convex-and-concave surfaces 124 of walking beam 123.

After walking beams 123 advances by the predetermined distance and stops, ascending-and-descending bodies in-drying portion 121 ascend, and then all suspending-use rod-like body 41 is placed on the be with at holding-use convex-and-concave surfaces of ascending-and-descending bodies in-drying portion 121. Repeat of such a reciprocative movement allows a group of ten bodies of suspending means 40 to intermittently advance step by step like a measuring worm.

(discharging-side base plate receiving-and-giving portion G, and discharging-side base plate descending portion H:G=D, H=C.)

The discharging-side base plate receiving-and-giving portion G is the same in the structure as the supplying-side base plate receiving-and-giving portion D. Still on condition that discharging-side base plate receiving-and-giving portion G is symmetrically located in relation to supplying-side base plate receiving-and-giving portion D with respect a certain plane. All the parts

of discharging-side base plate receiving-and-giving portion G are respectively the same as all the parts of supplying-side base plate receiving-and-giving portion D. Because both all the parts which are symmetrically located are symmetrical in movements with respect to the plane, both movements are mutually reversed in directions with respect to the before and behind relation and the right and left relation.

The discharging-side base plate descending portion H is the same in the structure as the supplying-side ascending portion C on condition that discharging-side base plate descending portion H is symmetrically located in relation to supplying-side ascending portion C with respect a certain plane. All the parts of discharging-side base plate descending portion H are respectively the same as all the parts of supplying-side ascending portion C. Because both all the parts which are symmetrically located are symmetrical in movements with respect to the plane, both movements are mutually reversed in directions with respect to the before and behind relation and the right and left relation.

One group of suspending means 40 at the forefront portion of walking biem 123 are transmitted and placed on placing bed 53 (which corresponds to placing bed 53 in Fig.7) of discharging-side base plate descending portion H according to the rotation of transmitting-use rotating arms 86 of discharging-side base plate receiving-and-giving portion G, the direction of the rotation being symmetrically reverse to the direction of the rotation in Fig.19.

(discharging-side posture transforming portion I:I=B)

The discharging-side posture transforming portion I is the same in the structure as the supplying-side posture transforming portion B on condition that discharging-side posture transforming portion I is symmetrically located in relation to supplying-side posture transforming portion B with respect a certain plane. All the parts of discharging-side posture transforming portion I are respectively the same as all the parts of supplying-side posture transforming portion B because both all the parts which are symmetrically located are symmetrical in movements with respect to the plane, both movements are mutually reversed in directions with respect to the before and behind relation and the right and left relation.

(base plate discharging portion J:J=A)

The base plate discharging portion J is the same in the structure as the base plate supplying portion A on condition that base plate discharging portion J is symmetrically located in relation to base plate supplying portion A with respect a certain plane. All the parts of base plate discharging portion J are respectively the same as all the parts of base plate supplying portion A because both all the parts which are symmetrically located are symmetrical in movements with respect to the plane, both movements are mutually reversed in directions with respect to the before and behind relation and the right and left relation.

A circuit base plate W is inserted into vertically oriented gripping means 12 of discharging-side posture transforming portion I from the upper side. The posture is transformed to be oriented in the horizontal direction by gripping means 12, the rotating portions of which are symmetrically located, but do not rotate with reverse relation between both rotations, and then is coveyed on rubber-made rollers 9 to be sent out.

(receiving-and-giving return-passage portion P, and returning portion Q)

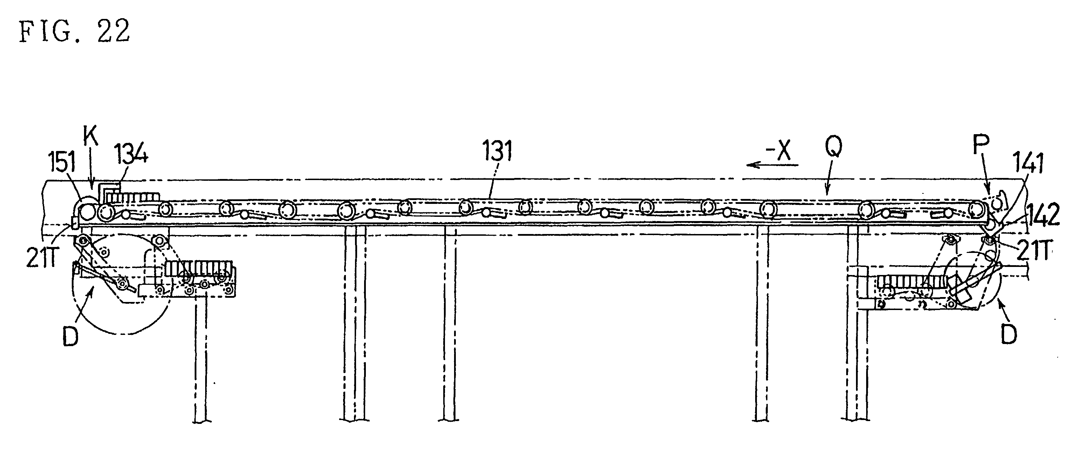

Fig.22 illustrates the receiving-and-giving return-passage portion P. The returning portion Q includes two ways of endless circulatively returning-use belt 131. Returning-use belt 131 are supported by supporting pullies which are located at a appropriate multiple of positions.

The portion of returning-use belt 131, the portion forming returning portion Q, advances in the minus X-axis (-X-axis) direction. Suspending means 40, the number of which exceeds the minimum number at least necessary are simultaneously on returning-use belt 131. The remaining numbers of suspending means 40 are stopped by stoppers 134 which are located at the rear side portion, staying at rest in the state where the before side and behind side of neighboring suspending means 40 are mutually pushed. As such, the portion of returning-use belt 131 is formed as returning portion Q.

Fig.22 illustrates the receiving-and-giving return-passage portion P. Carrying-use rotatable arm 141 is rotatably provided at the position near the front end portion of returning-use belt 131. Nails portion 142 which stand up with being oriented in the rotational direction are formed at the free end portion of carrying-use rotatable arm 141. Carrying-use rotatable arm 141 of suspending means 40 which is supported at the ascending position 21T as shown in Fig.8 by ascending-descending base 21, which is symmetrically located with respect to a certain plane in relation to ascending-descending base 21 as shown in Fig.8, is inserted into and scooped by the concave portion of nails portion 142, and is thrown out upon returning-use belt 131 due to the force of gravity when carrying-use rotatable arm 141 rotates by an appropriate degrees in angle.

(receiving-and-giving go-passage portion K)

Fig.22 illustrates the receiving-and-giving go-passage portion K. A carrying-use rotatable plate 151 is rotatably provided at the position near the rear end portion of returning-use belt 131. One or a multiple of concave portion(s) is or are provided on the circumference of carrying-use rotatable plate 151. When the opening and closing stopper 134 opens, only one of suspending means 40 on returning-use belt 131 drops into one of the concave portions. The suspending means 40 which is placed into the concave portion descends during carrying-use rotatable plate 151 rotates by the predetermined angle of rotation, and is positioned at the upper position 21T shown in Fig. 8, being placed on ascending-descending base 21.

(downward go-passage portion L and upward return passage portion O)

The downward go-passage portion L as well as the upward return passage portion O includes a ascending and descending means including ascending-descending base 21 shown in Fig.8, and a means which is symmetrically located in relation to the above ascending and descending means with respect to a certain plane.

(upward go-passage portion M and downward return-passage portion N)

The upward go-passage portion M and the downward return-passage portion N are respectively identical with the supplying-side ascending portion C and the discharging-side base plate descending portion H.

(actuating and a method therefor)

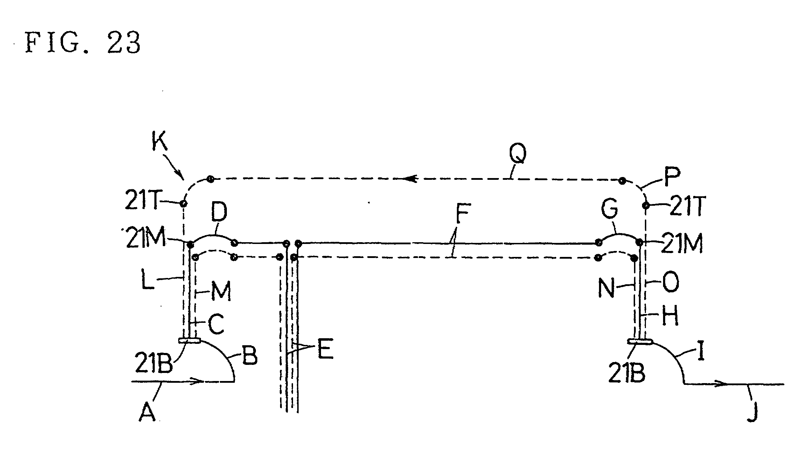

Suspending means 40 ciculatively flow. Works flows in the one way direction. The suspending means 40 and the works flow together on the common portion of the whole conveying ways. Fig.23 illustrates the flows referring to the suspending means 40 and the works. The real line shows the flow of suspending means 40, while the dotted line shows the flow of the works. The conveying way portions, which respectively form one and the same conveying ways with suspending means 40 and the works flowing together, correspond to supplying-side ascending portion C (identical with upward go-passage portion M), supplying-side base plate receiving-and-giving portion D, common drying process portion F, discharging-side base plate receiving-and-giving portion G, and discharging-side base plate descending portion H (identical with downward return-passage portion N).

Each of supplying-side ascending portion C,. downward go-passage portion L and upward go-passage portion M include an ascending-descending means same as the ascending-descending means shown in Fig.8. Each of discharging-side base plate descending portion H, downward return-passage portion N and upward return passage portion O include an ascending-descending means same as the ascending-descending means which is symmetrically located in relation to the ascending-descending means shown in Fig.

8.

Dipping process conveying portion E continuously connects with supplying-side ascending portion C, downward go-passage portion L and upward go-passage portion M as the conveying system in geometry, mathematics and programming, but intermittently connects with supplying-side ascending portion C, downward go-passage portion L and upward go-passage portion M as the conveying system in physics and mechanism. In other word, it does not mechanically connects with them. During suspending-use rod-like body 41 are ascending or descending in dipping process conveying portion E, the movable portion of supplying-side base plate receiving-and-giving portion D does not physically connects with the movable portion of dipping process conveying portion E. During suspending-use rod-like body 41 are ascending or descending in dipping process conveying portion E, the movable portion of common drying process portion F does not physically connects with the movable portion of dipping process conveying portion E. In other words, dipping process conveying portion E is mechanically and physically intermittent and independent in relation to the conveying way portions which are before and behind the dipping process conveying portion E.

Accordingly, dipping process conveying portion E is independent of or intermittent in relation to the following portions:the base plate supplying portion A, the supplying-side posture transforming portion B, the supplying-side ascending portion C, the supplying-side base plate receiving-and-giving portion D, the drying process portion F, the discharging-side base plate receiving-and-giving portion G, the discharging-side base plate descending portion H, the discharging-side posture transforming portion I, the base plate discharging portion J, the receiving-and-giving go-passage portion K, the downward go-passage portion L, the upward go-passage portion M, the downward return-passage portion N, the upward return passage portion O, the receiving-and-giving return-passage portion P, and the returning portion Q.

The circuit base plates in base plate supplying portion A have the respective electrode layers, the surfaces of which had been polished. The circuit base plates in base plate supplying portion A, which is supported at many points, are not forced as they are bended. The surface of each of the circuit base plates, the posture of which is transformed in the vertical direction, is suspended with the upper end portion thereof being gripped by suspending-use gripping means 42 of suspending means 40 so that it is naturally placed along a vertical plane by the force of gravity. Such a vertically suspended circuit base plate is facilitated to be dried by the upward flowing air in drying process portion F.

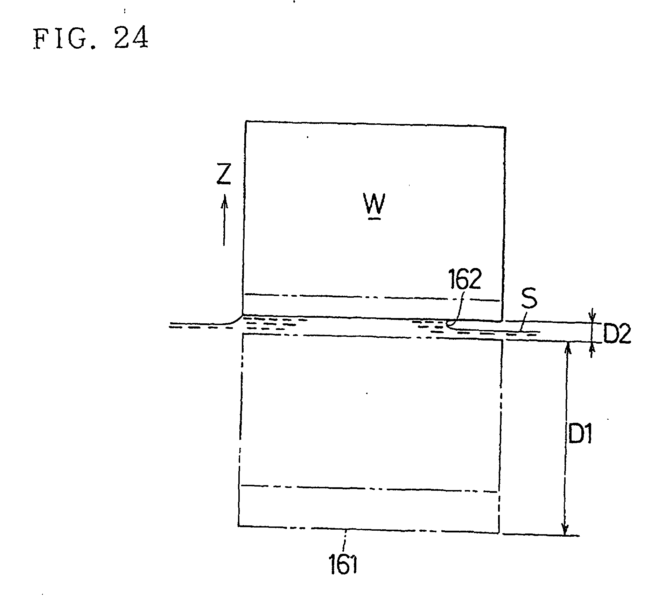

Fig.24 shows a desirable method of dipping in drying process portion F. Such method is detailedly described through Japanese Patent Application No. Heisei 9-70626. Briefly explaining such method, a circuit base plate W ascends and descends with the straight line-like lower end 161 slightly inclining against the liquid surface or being parallel to the liquid surface. The circuit base plate W ascends with the high speed at the section D1 from the lowest position to the position just before the position where it leaves the liquid to be cut by the lower end of the plate, and ascends with the lower speed or is at rest at the section D2 from the position just before the position where it leaves the liquid to be cut to the position where it leaves the liquid to be cut. During the plate W. is at the section D2, single meniscus 162, which is formed between the lower end and the liquid surface, runs in the horizontal direction with a considerably higher speed from one end portion to another end portion of the space formed between of the lower end and the liquid surface. The remaining liquid on the lower portion of the plate is pulled to be facilitated to be separated from the plate liquid by the surface side liquid due to the surface tension through the meniscus 162. Such liquid cutting makes the thickness of the thin liquid layer uniform.

To make the speed at the section D1 higher makes the time of the process shorter, The uniformity of the thickness of the layer greatly depends on the velocity of the meniscus 162. The higher the speed is, the more violently wave-like shaking occurs on the surface of a base plate, the thickness of which is very much thinly formed such as 0.06 mm. The velocity of the meniscus is not independent of the frequency of the base plate, the s0haking or the turbulence of the liquid near the liquid surface due to the frequency. The base plate which receives such frequency facilitates the wave-like movement og the liquid surface.

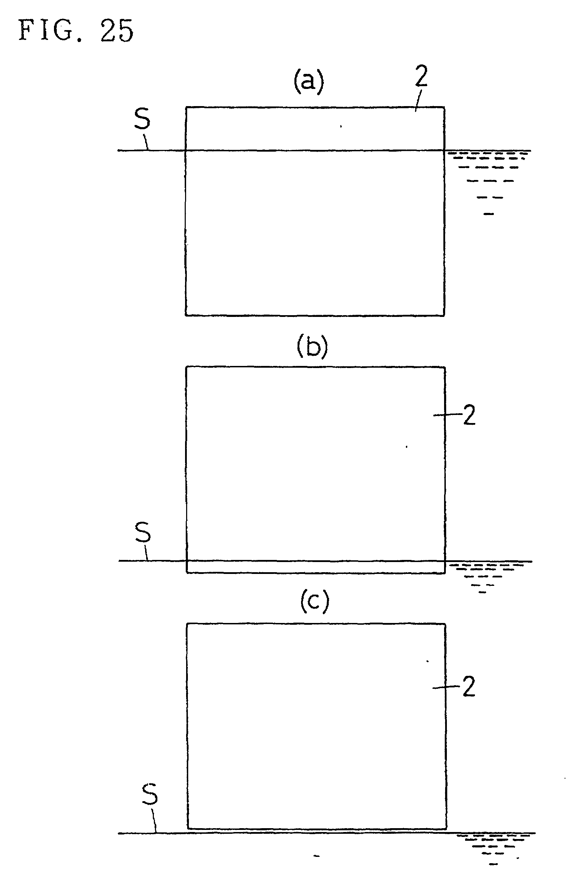

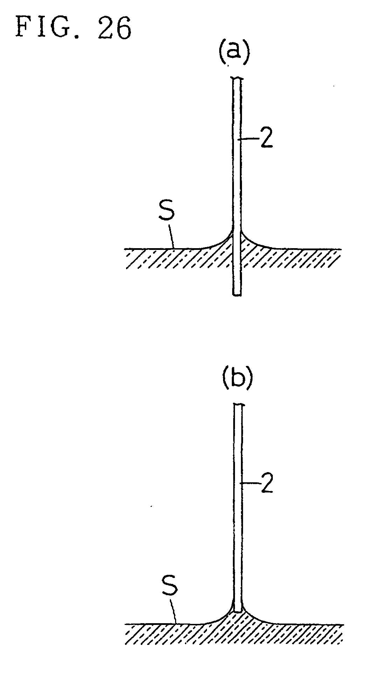

Figs.25-32 shows a more detailed analysis referring to such a slowly running meniscus. Fig.25 (b) illustrates base plate 2 that sinks with only the lower end portion sinking into the liquid. As shown in Figs. 26 (a) and 26 (a), a first vertical meniscus M1 is formed. First vertical meniscus M1 is formed on both sides of the base plate. The base plate has two liquid-layer forming portions, which comprises a first liquid-layer forming portion T1 and a second liquid-layer forming portion T2. The thickness of first liquid-layer forming portion T1 is generally uniform. The thickness of second liquid-layer forming portion T2 is not uniform because of the being of the bulge of the vertical meniscus positioned near to the surface of the tank-side resist-liquid. First vertical meniscus M1 is effective in order that it makes the thickness thinner. The liquid of second liquid-layer forming portion T2 is pulled, and accordingly flows in the downward direction by gravity and surface tension towards the surface S of the tank-side resist-liquid.

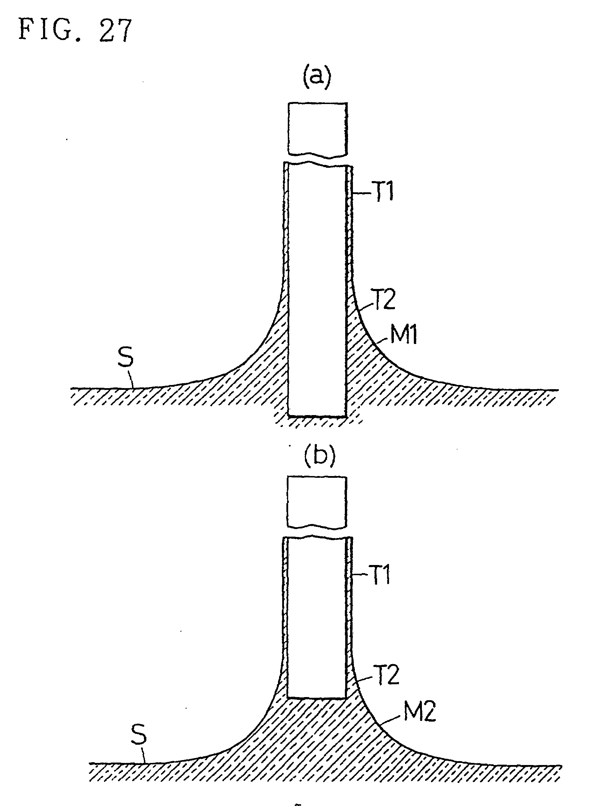

Fig.25 (c) illustrates base plate 2, the lower end line of which is positioned at a position in height slightly higher than the surface of the tank-side liquid. Without any surface tension, the base plate would perfectly leave the tank-side liquid. However, as shown in Figs.26 (b) and 27 (b), a second vertical meniscus M2 is further effective in order that the remaining liquid is removed from the plate. Second vertical meniscus is also formed on both sides of the plate. Second liquid-layer forming portion T2 which is shown in Fig.20 (b) more fastly flows in the downward direction than second liquid-layer forming portion T2 which is shown in Fig.27 (a). The liquid of second vertical meniscus M2 shown in Fig.27 (b) is more strongly pulled towards the tank-side.

The slower the velocity is, the more the amount of the liquid of the meniscus portion which is pulled by the tank-side liquid and removed from the plate is. The velocity of the slow motion during the period when the meniscus is formed is set lower than one hundredth of the velocity of the faster motion during the period when the meniscus is not formed as shown in Figs.25(a) and 25(b), and higher set than one tenth of the velocity of the faster motion. 01. The velocity of the slow motion is particularly set as one by the frequency of inverter motor (not shown), which is several Hz.

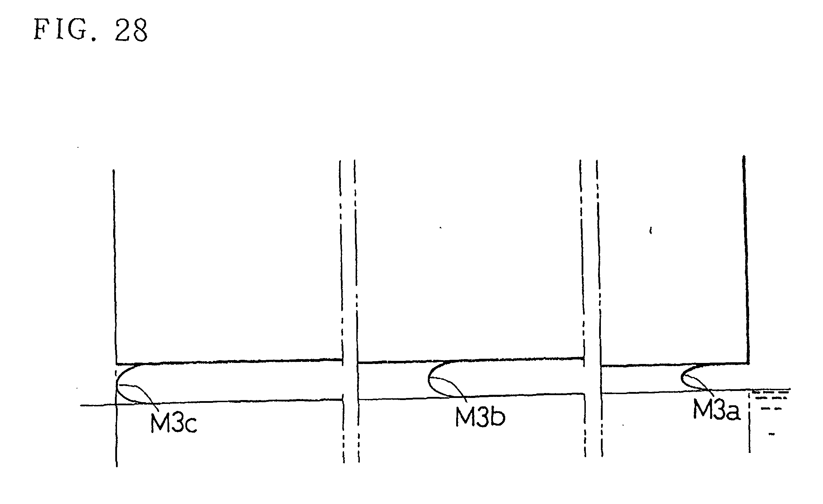

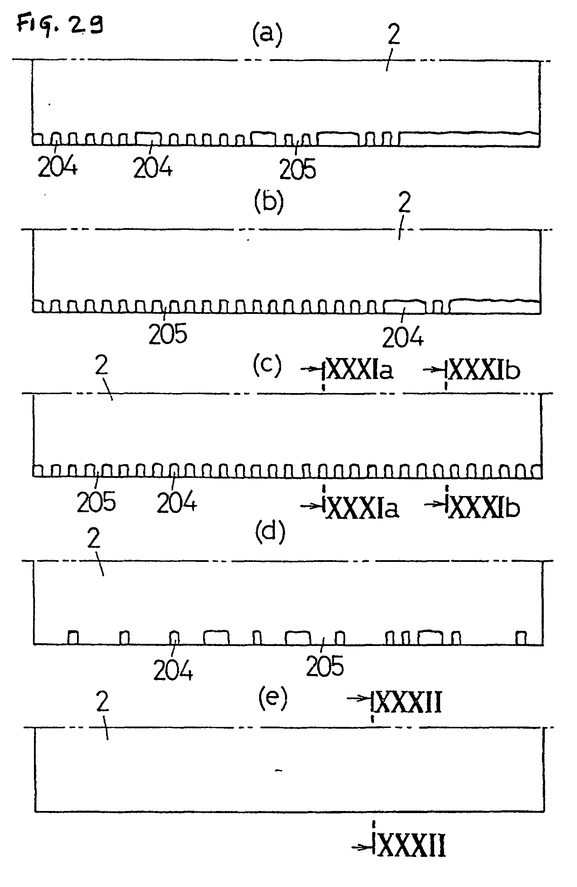

During such second vertical meniscus M2 is formed, a horizontal meniscus is formed as shown in Fig.28, which illustrates three aspects of meniscuses M3a, M3b, and M3c. Horizontal meniscus M3 runs in the left hand direction on Fig.21. If the lower end line of the plate is theoretically parallel to the surface of the liquid, the direction of motion of the meniscus would be uncertain. However, because of the being of the breaking of symmetry of the devices within a mechanical clearance which the machine necessarily has and the clearance of the plate which is generated when it is made, the meniscus necessalily runs with high speed in either direction of the left hand and right hand directions. The running meniscus cleans the remaining liquid on the surface of the lower end portion of the plate, thereby the liquid of second liquid-layer forming portion T2 is scanned and absorbed to the liquid side.

While horizontal meniscus M3 is running, The base plate slightly moves in the upward direction. Horizontal meniscus M3a, horizontal meniscus M3b, and horizontal meniscus M3c, which are slightly different in form, are the same in function. The base plate moves so slowly that meniscus M3 runs from the one end to the other end, even if the lower end line is parallel to the surface of the liquid. These meniscuses M3a, M3b, and M3c pulls the liquid with the uniformly pulling force.

The viscosity may be lower than 40 cps, and the spatial interval between the lower end line and the surface of the liquid may be 2-3 mm in order that the time interval during the state of the slow motion is kept may be identical to the interval during the horizontal meniscus hand the vertical meniscus are formed. The liquid of second liquid-layer forming portion T2 is removed by the scanning of the running meniscus.

The upward directional velocity is considerably higher after the lower end portion leaves the liquid in order that the cycled time on the one process is shortened. A resist-liquid circulation pump (not shown) is desirably stopped during the period when the meniscus is formed. The circulating pump again starts to be driven after the lower end line of the olate wholely leaves the surface of the resist liquid. The vibration of the liquid has no influence to the thickness of the layer after the plate leaves the resist-liquid.

The present invention is not defined within the above described embodiments. For example, referring to a liquid-cutting angle θ that is defined as an angle between the lower end line of a plate and the surface of resist liquid.A liquid-cutting angle is not merely zero, but it is desirable that the angle is considerably small. The angle θ may be assymptoticly zero within one hundred and twentieths radians with the upward directional velocity being considerably slow on any occasions.

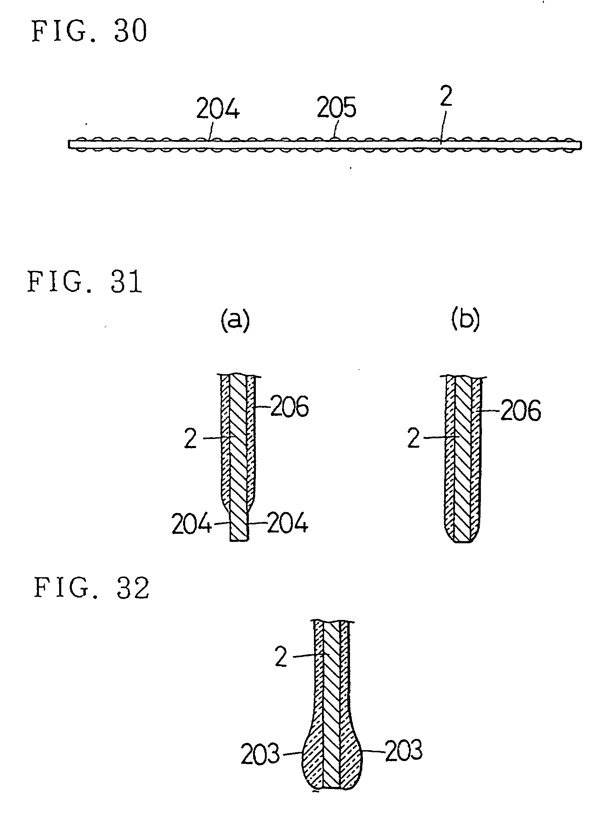

Fig.29 shows an embodiment according the present invention in comparison with a prior art. The upward directional velocities on the respective liquid-cutting process respectively corresponds to 1 Hz in Fig.29 (a), 3Hz in Fig.29 (b), 5 Hz in Fig.29 (c), 7 Hz in Fig.29 (d), 100 Hz (for the prior art) in Fig.29 (e). The velocity is proportional to a frequency of a invertor motor. The coated plate shown in Fig.29 (e) has a bulge of the lower end portion thereof as seen on the section shown in Fig. 32.

The respective portions 204 illustrated in Figs. 29 (a)-(d) has almost no thicknesses of the respective layers. As shown in Fig.29 (c), the resist-materials-coated portions wave-likely distributes along the lower end line in the direction in which the meniscus runs. The coated portions and the non-coated portions are alternatively arranged. One coated portion is inserted between two non-coated portions. As shown in Fig.29 (c), there appears about 50 positions of coated portions on the lower end portion of one base plate, the horizontal length of which is 300 mm. Figs.31 (a) and (b) illustrates the sections noted at two positions in Fig.29 (c). As shown in Fig.31 (a) and (b), the thickness of the resist-coated portion 205 is thinner than the thickness of the medium portion 206 which is higher in height than the lower end portion. The thickness of the non-coated portion 204 is substantially zero. In the case of 7 Hz, the area of the non-coated portion 204 is narrower. As illustrated in Fig.31, the thickness of the base plate is 1-3 mm, and the thickness of the portion 206 is about 10 μm.

The reason why the lower end coated portion is wave-likely formed in thickness may be described as follows: When the coated liquid on the lower end portion of the plate moves in the horizontal direction, where the horizontal motion is induced by the motion of the meniscus, moves in the same direction. The moment of the meniscus brings out reaction of the liquid facing against the moving meniscus. The action and the reaction brings out vibration of the liquid of the lower end portion. Such vibration brings out the distribution of thickness which is wave-likely formed. The wave-like bulge of the portion, the concave portions are formed between the two neighboring bulges, are pulled on the tank-side (liquid side) by the surface tension, and absorbed into the tank-side liquid. Such a concave portion happens to have no thickness with the surface of a base plate such as the surface of a cooper layer appearing.

According to the present invention, works silently move without shaking thereof and turbulence of the liquid, because the works do not receive any frequency from the conveying way means other than dipping process conveying portion E, while a meniscus silently movres and the motion of the meniscus is independent of the motion of the conveying system(s).

**Claims**

1. A method for forming a resist layer on a circuit base plate comprising the set of steps:

   circulating grippers (12) on a circulatively conveying way,

   suspending circuit base plates (W) in the respective vertical postures thereof with the respective upper portions of said circuit base plates (W) being gripped by the corresponding grippers,

   downward-driving said grippers (12) in the downward direction so that said circuit base plates are dipped into resist liquid respectively,

   upward-driving said grippers (12) in the upward direction so that said circuit base plates (W) are respectively withdrawn from said resist liquid, and

   forming a continuous flow on a one-directionally conveying way where said circuit base plates (W) are continuously driven,

   the forming system for said forming being mechanically independent of the downward-driving system for said downward-driving,

   **characterized in that** the respective lower surfaces of said circuit base plates (W) of said continuous flow are supported at a multiple of points in the respective generally horizontal postures.

2. A method for forming a resist layer on a circuit base plate of claim 1 further comprising transforming said horizontal postures of said circuit base plates (W) to the generally vertical postures, further **characterized in that** the transforming system for said transforming is mechanically independent of said downward-driving system.

3. A method for forming a resist layer on a circuit base plate of claim 1, further **characterized in that** the transforming system for said transforming is mechanically independent of said upward-driving system.

4. A method for forming a resist layer on a circuit base plate of claim 2, further comprising forwarding said circuit base plates (W) have been respectively withdrawn from said resist liquid, further **characterized in that** the forwarding system for said forwarding is mechanically independent of said downward-driving system.

5. A method for forming a resist layer on a circuit base plate of claim 4, further **characterized in that** the forwarding system for said forwarding is mechanically independent of said upward-driving system.

6. A method for forming a resist layer on a circuit base plate of claim 1, further **characterized by** the steps of transforming said horizontal postures of said circuit base plates (W) to the generally vertical postures, and forwarding said circuit base plates (W) have been respectively withdrawn from said resist liquid, said downward-driving system and said upward-driving system being respectively mechanically independent of all of said forming system, the transforming system for said transforming, and the forwarding system for said forwarding.

7. A method for forming a resist layer on a circuit base plate of claim 1, said set being further **characterized by** the steps:

   lowering the velocity of said upward-direction motion on the process of cutting said resist liquid by the lower end portion of said base plate (W) so that a single meniscus (M3a,M3b,M3c) runs from the one end portion of said lower end portion to the other end portion of said lower end portion, said meniscus (M3a,M3b,M3c) being formed between the lower end portion and the surface of said resist-liquid.

8. A method for forming a resist layer on a circuit base plate of claim 7, wherein the lower end line of said lower end portion is substantially horizontal.

9. A method for forming a resist layer on a circuit base plate of claim 7, wherein said velocity is higher than one hundredth of the maximum velocity on the process of said upward-driving, and said velocity is lower than one tenth of said maximum velocity.

10. A method for forming a resist layer on a circuit base plate of claim 7, wherein the coefficiency of viscosity of said resist-liquid is lower at 25 degrees Celsius than 40 cps, and the average of the velocity before entering into the process of said cutting is higher than 10 mm a second, and said average is lower than 70 mm a second, while said velocity on the process of said cutting is higher than 0.1 mm a second, and said velocity on the process of said cutting is lower than 1.0 mm a second.

11. A method for forming a resist layer on a circuit base plate of claim 7, wherein said base plate (W) does not leave the surface of said resist-liquid before the meniscus-forming portion of said resist-liquid runs from the one end of said lower end of said base plate (W) to the other end thereof, said meniscus-forming portion being formed between said lower end of said base plate and the surface of said resist-liquid.

12. A method for forming a resist layer on a circuit base plate of claim 7, wherein the time during the process of said cutting is not shorter than the time during the running of said meniscus-forming portion from said one end to said other end.

13. A method for forming a resist layer on a circuit base plate of claim 7, wherein said base plate is at rest on the process of said cutting.

14. A method for forming a resist layer on a circuit base plate of claim 7, said set comprising a further step: raising the velocity of said upward-direction movement after said base plate leaves the surface of said resist-liquid.

15. A method for forming a resist layer on a circuit base plate of claim 7, wherein the velocity of said meniscus (M3a,M3b,M3c) frequently varies while said meniscus runs from the one end of said lower end of said base plate (W) to the other end of said lower end.

16. A method for forming a resist layer on a circuit base plate of claim 7, the resist layer of said lower end portion including thinner portions and thicker portions, wherein the velocity of said meniscus frequently varies while said meniscus (M3a,M3b,M3c) runs from the one end of said lower end of said base plate to the other end of said lower end so that said thicker portions and said thinner portions appear alternatively.

17. An electronic circuit plate formed by the method according to claims 1 to 16, **characterized in that** the resist-liquid is applied to said base plate in a way that the base plate leaves said resist liquid with a thin resist-layer formed on the surface of said base plate, said base plate leaving said resist liquid on a vertical plane,

said resist-layer including a lower end layer and a medium layer, said medium layer being formed on the medium portion of said base plate between said lower end layer and the upper end of said base plate, said lower end layer cutting said resist-liquid while said base plate leaves said resist-liquid,

wherein the thickness of said lower end layer is not thicker than that of the medium layer.

18. An electronic circuit plate of claim 17, wherein the thickness of said lower end layer wave-likely varies on the horizontal line on said lower end portion of said base plate.

19. An electronic circuit plate of claim 17, wherein said lower end layer includes thinner portions and thicker portions, said thinner portions being thinner than said thicker portions wherein each of said thinner portions is situated between one of said thicker portions and another of said thicker portions which is next to said one of said thicker portions.

20. An electronic circuit plate of claim 17, wherein said lower end layer includes thinner portions and thicker portions, said thinner portions and said thicker portions appearing alternatively.

**Patentansprüche**

1. Verfahren zur Bildung einer Resistschicht auf Leiterplatten, mit den Schritten:

umlaufendes Transportieren von Greifvorrichtungen auf einer geschlossenen Förderbahn,

Aufhängen von Leiterplatten in senkrechter Anordnung, bei der die oberen Bereiche der Leiterplatten durch die entsprechenden Greifvorrichtungen erfaßt werden,

Absenken der Greifvorrichtungen in Abwärtsrichtung, so daß die Leiterplatten in die Resistflüssigkeit eingetaucht werden,

Anheben der Greifvorrichtungen in Aufwärtsrichtung, so daß die Leiterplatten aus der Resistflüssigkeit herausgezogen werden,

Bilden eines kontinuierlichen Stroms in ein und derselben Förderrichtung unter ständigem Antreiben der Leiterplatten,

wobei das Bildungssystem mechanisch unabhängig von dem System zum Absenken ist, **dadurch gekennzeichnet, daß** die unteren Oberflächen der Leiterplatten des kontinuierlichen Stroms in einer Mehrzahl von Punkten in im wesentlichen waagerechter Stellung abgestützt werden.

2. Verfahren zur Bildung einer Resistschicht auf einer Leiterplatte gemäß Anspruch 1, bei dem die horizontalen Stellungen der Leiterplatten in im wesentlichen senkrechte Stellungen umgewandelt werden, **dadurch gekennzeichnet, daß** das Umwandlungssystem mechanisch unabhängig von dem Absenksystem ist.

3. Verfahren zur Bildung einer Resistschicht auf einer Leiterplatte gemäß Anspruch 1, **dadurch gekennzeichnet, daß** das Umwandlungssystem zum Umwandeln mechanisch unabhängig von dem Aufwärtsbewegungssystem ist.

4. Verfahren zur Bildung einer Resistschicht auf einer Leiterplatte gemäß Anspruch 2, bei dem die Leiterplatten vorwärts transportiert werden, nachdem sie aus der Resistflüssigkeit gezogen worden sind, **dadurch gekennzeichnet, daß** das Vorwärtstransportsystem mechanisch unabhängig von dem Absenksystem ist.

5. Verfahren zur Bildung einer Resistschicht auf einer Leiterplatte gemäß Anspruch 4, **dadurch gekennzeichnet, daß** das Vorwärtstransportsystem mechanisch unabhängig von dem Aufwärtstransportsystem ist.

6. Verfahren zur Bildung einer Resistschicht auf einer Leiterplatte gemäß Anspruch 1, **gekennzeichnet durch** die Schritte:

   Umwandeln der horizontalen Stellungen der Leiterplatten in im wesentlichen senkrechte Stellungen,

   Vorwärtstransport der Leiterplatten, die aus der Resistflüssigkeit gezogen worden sind,

   wobei das Abwärtstransportsystem und das Aufwärtstransportsystem mechanisch unabhängig von dem Bildungssystem, dem Umwandlungssystem und dem Vorwärtstransportsystem sind.

7. Verfahren zur Bildung einer Resistschicht auf einer Leiterplatte gemäß Anspruch 1, **gekennzeichnet durch** die Schritte:

   Senken der Geschwindigkeit der Aufwärtsbewegung bei dem Verfahren des Schneidens der Resistflüssigkeit **durch** den unteren Endbereich der Leiterplatte, so daß ein einzelner Flüssigkeitsspiegel von einem Ende des unteren Endbereichs zum anderen Ende des unteren Endbereichs verläuft, welcher Flüssigkeitsspiegel (M3a,M3b,M3c) gebildet wird zwischen dem unteren Endbereich und der Oberfläche der Resistflüssigkeit.

8. Verfahren zur Bildung einer Resistschicht auf einer Leiterplatte gemäß Anspruch 7, bei dem die untere Endlinie des unteren Endbereichs im wesentlichen waagerecht ist.

9. Verfahren zur Bildung einer Resistschicht auf einer Leiterplatte gemäß Anspruch 7, bei dem die Geschwindigkeit höher als 1/100 der maximalen Geschwindigkeit bei dem Verfahren der Aufwärtsbewegung ist und die Geschwindigkeit niedriger als 1/10 der maximalen Geschwindigkeit ist.

10. Verfahren zur Bildung einer Resistschicht auf einer Leiterplatte gemäß Anspruch 7, bei dem der Viskositäts-Koeffizient der Resistflüssigkeit bei 25° C niedriger als 40 cps ist und der Durchschnitt der Geschwindigkeit vor dem Eintritt in das Verfahren des Einschneidens höher als 10 mm pro Sekunde ist und der Durchschnitt niedriger als 70 mm pro Sekunde ist, während die Geschwindigkeit des Verfahrens des Einschneidens höher als 0,1 mm pro Sekunde ist und niedriger als 1,0 mm pro Sekunde.

11. Verfahren zur Bildung einer Resistschicht auf einer Leiterplatte gemäß Anspruch 7, bei dem die Leiterplatte die Oberfläche der Resistflüssigkeit nicht verläßt, bevor der den Flüssigkeitsspiegel bildende Bereich der Resistflüssigkeit von einem Ende des unteren Endbereichs der Basisplatte zum anderen Ende gelaufen ist, welcher den Flüssigkeitsspiegel bildende Bereich zwischen dem unteren Ende der Leiterplatte und der Oberfläche der Resistflüssigkeit gebildet ist.

12. Verfahren zur Bildung einer Resistschicht auf einer Leiterplatte gemäß Anspruch 7, bei dem die Zeit während des Verfahrens des Einschneidens nicht kürzer ist als die Zeit während des Laufes des den Flüssigkeitsspiegel bildenden Bereichs von einem Ende zum anderen.

13. Verfahren zur Bildung einer Resistschicht auf einer Leiterplatte gemäß Anspruch 7, bei dem die Leiterplatte bei dem Verfahren des Einschneidens in Ruhe ist.

14. Verfahren zur Bildung einer Resistschicht auf einer Leiterplatte gemäß Anspruch 7, **gekennzeichnet durch** den weiteren Schritt des Anhebens der Geschwindigkeit der Aufwärtsbewegung, nachdem die Leiterplatte die Oberfläche der Resistflüssigkeit verlassen hat.

15. Verfahren zur Bildung einer Resistschicht auf einer Leiterplatte gemäß Anspruch 7, bei dem die Geschwindigkeit des Flüssigkeitsspiegels (M3a,M3b, M3c) häufig wechselt, während der Flüssigkeitsspiegel von einem Ende des unteren Endbereichs der Leiterplatte zum anderen Ende läuft.

16. Verfahren zur Bildung einer Resistschicht auf einer Leiterplatte gemäß Anspruch 7, welche Resistschicht am unteren Endbereich dünnere und dickere Bereiche umfaßt, wobei die Geschwindigkeit des Flüssigkeitsspiegels häufig wechselt, während der Flüssigkeitsspiegel (M3a,M3b,M3c) von einem Ende des unteren Endbereichs der Leiterplatte zum anderen Ende läuft, so daß die dickeren Bereiche und die dünneren Bereiche abwechselnd auftauchen.

17. Elektronische Leiterplatte gemäß einem der Ansprüche 1 bis 16, **dadurch gekennzeichnet, daß** die Resistflüssigkeit auf die Leiterplatte derart aufgebracht ist, daß die Leiterplatte die Resistflüssigkeit mit einer dünnen Resistschicht auf der Oberfläche verläßt, wobei die Leiterplatte die Resistflüssigkeit auf einer senkrechten Ebene verläßt,

welche Resistschicht eine untere Endschicht und eine mittlere Schicht umfaßt, welche mittlere Schicht auf den mittleren Bereich der Leiterplatte zwischen dem unteren Ende und dem oberen Ende der Leiterplatte gebildet ist, wobei die untere Endschicht die Resistflüssigkeit schneidet, während die Leiterplatte die Resistflüssigkeit verläßt,

wobei die Dicke der unteren Endschicht nicht größer ist als diejenige der mittleren Schicht.

18. Elektronische Leiterplatte gemäß Anspruch 17, bei der die Dicke der unteren Endschicht wellenförmig auf einer horizontalen Linie auf dem unteren Endbereich der Leiterplatte wechselt.

19. Elektronische Leiterplatte gemäß Anspruch 17, bei der die untere Endschicht dünnere Bereiche und dickere Bereiche umfaßt, welche dünneren Bereiche dünner sind als die dickeren Bereiche, wobei jeder der dünneren Bereiche zwischen einem der dickeren Bereiche und einem weiteren, diesem nahegelegenem dickeren Bereich liegt.

20. Elektronische Leiterplatte gemäß Anspruch 17, bei der die untere Endschicht dünnere Bereiche und dickere Bereiche umfaßt und die dünneren Bereiche und die dickeren Bereiche abwechselnd auftreten.

## Revendications

1. Procédé pour former une couche de réserve sur une plaque de base de circuit comportant les étapes consistant à :

faire circuler des dispositifs de saisie (12) sur un chemin de transport circulaire,
suspendre les plaques de base de circuit (W) dans leurs postures verticales respectives, les parties supérieures respectives desdites plaques de base de circuit (W) étant saisies par les dispositifs de saisie correspondants,
faire descendre lesdits dispositifs de saisie (12) dans la direction vers le bas de sorte que lesdites plaques de base de circuit sont respectivement trempées dans du vernis de réserve liquide,
faire monter lesdits dispositifs de saisie (12) dans la direction vers le haut de sorte que lesdites plaques de base de circuit (W) sont respectivement extraites dudit vernis de réserve liquide, et
former un écoulement continu sur un chemin de transport unidirectionnel où lesdites plaques de base de circuit (W) sont entraînées en continu,
le système de formation pour ladite formation étant mécaniquement indépendant du système d'entraînement vers le bas destiné à faire descendre,

**caractérisé en ce que** des surfaces inférieures respectives desdites plaques de base de circuit (W) dudit écoulement continu sont supportées en des points multiples dans les postures généralement horizontales respectives.

2. Procédé pour former une couche de réserve sur une plaque de base de circuit selon la revendication 1, comportant de plus la transformation desdites postures horizontales desdites plaques de base de circuit (W) en postures généralement verticales,
**caractérisé en outre en ce que** le système de transformation destiné à ladite transformation est mécaniquement indépendant dudit système d'entraînement vers le bas.

3. Procédé pour former une couche de réserve sur une plaque de base de circuit selon la revendication 1, **caractérisé en outre en ce que** le système de transformation destiné à ladite transformation est mécaniquement indépendant dudit système d'entraînement vers le haut.

4. Procédé pour former une couche de réserve sur une plaque de base de circuit selon la revendication 2, comportant de plus l'acheminement desdites plaques de base de circuit (W) qui ont été respectivement retirées dudit vernis de réserve liquide,
**caractérisé en outre en ce que** le système d'acheminement destiné audit acheminement est mécaniquement indépendant du système d'entraînement vers le bas.

**5.** Procédé pour former une couche de réserve sur une plaque de base de circuit selon la revendication 4,

    **caractérisé en outre en ce que** le système d'acheminement destiné audit acheminement est mécaniquement indépendant dudit système d'entraînement vers le haut.

**6.** Procédé pour former une couche de réserve sur une plaque de base de circuit selon la revendication 1, **caractérisé en outre en ce qu'**il comporte les étapes consistant à :

    transformer lesdites postures horizontales desdites plaques de base de circuit (W) en postures généralement verticales, et
    acheminer lesdites plaques de base de circuit (W) qui ont été respectivement retirées dudit vernis de réserve liquide,
    ledit système d'entraînement vers le bas et ledit système d'entraînement vers le haut étant respectivement mécaniquement indépendants de tout l'ensemble constitué dudit système de formation, du système de transformation destiné à ladite transformation et du système d'acheminement destiné audit acheminement.

**7.** Procédé pour former une couche de réserve sur une plaque de base de circuit selon la revendication 1, ledit procédé étant en outre **caractérisé par** les étapes consistant à :

    à baisser la vitesse dudit mouvement dans la direction vers le haut lors du processus de coupure dudit vernis de réserve liquide par la partie d'extrémité inférieure de ladite plaque de base (W) de sorte qu'un ménisque unique (M3a, M3b, M3c) se déplace depuis la première partie d'extrémité de ladite partie d'extrémité inférieure vers l'autre partie d'extrémité de ladite partie d'extrémité inférieure, ledit ménisque (M3a, M3b, M3c) étant formé entre la partie d'extrémité inférieure et la surface dudit vernis de réserve liquide.

**8.** Procédé pour former une couche de réserve sur une plaque de base de circuit selon la revendication 7, dans lequel la ligne d'extrémité inférieure de ladite partie d'extrémité inférieure est sensiblement horizontale.

**9.** Procédé pour former une couche de réserve sur une plaque de base de circuit selon la revendication 7, dans lequel ladite vitesse est plus élevée qu'un centième de la vitesse maximum lors du processus d'entraînement vers le haut, et ladite vitesse est plus basse qu'un dixième de ladite vitesse maximum.

**10.** Procédé pour former une couche de réserve sur une plaque de base de circuit selon la revendication 7, dans lequel le coefficient de viscosité dudit vernis de réserve liquide est plus bas à 25 degrés Celsius que 40 cps, et la moyenne de la vitesse avant de pénétrer dans le processus de coupure est plus élevée que 10 mm par seconde, et ladite moyenne est plus basse que 70 mm par seconde, alors que ladite vitesse lors du processus de coupure est plus élevée que 0,1 mm par seconde, et ladite vitesse lors du processus de coupure est plus basse que 1,0 mm par seconde.

**11.** Procédé pour former une couche de réserve sur une plaque de base de circuit selon la revendication 7, dans lequel ladite plaque de base (W) ne quitte pas la surface dudit vernis de réserve liquide avant que la partie de formation de ménisque dudit vernis de réserve liquide ne se déplace depuis la première extrémité de ladite extrémité inférieure de ladite plaque de base (W) vers l'autre extrémité de celle-ci, ladite partie de formation de ménisque étant formée entre ladite extrémité inférieure de ladite plaque de base et la surface dudit vernis de réserve liquide.

**12.** Procédé pour former une couche de réserve sur une plaque de base de circuit selon la revendication 7, dans lequel la durée du processus de coupure n'est pas plus courte que la durée du déplacement de ladite partie de formation de ménisque depuis ladite première extrémité jusqu'à ladite autre extrémité.

**13.** Procédé pour former une couche de réserve sur une plaque de base de circuit selon la revendication 7, dans lequel ladite plaque de base est au repos lors du processus de coupure.

**14.** Procédé pour former une couche de réserve sur une plaque de base de circuit selon la revendication 7, comportant en outre une étape consistant à augmenter la vitesse dudit mouvement dans la direction vers le haut après que ladite plaque de base ait quitté la surface dudit vernis de réserve liquide.

**15.** Procédé pour former une couche de réserve sur une plaque de base de circuit selon la revendication 7, dans lequel la vitesse dudit ménisque (M3a, M3b, M3c) varie fréquemment alors que ledit ménisque se déplace depuis la première extrémité de ladite extrémité inférieure de ladite plaque de base (W) vers l'autre extrémité de ladite extrémité inférieure.

**16.** Procédé pour former une couche de réserve sur une plaque de base de circuit selon la revendication 7, la couche de réserve de ladite partie d'extrémité inférieure comportant des parties plus minces et des parties plus épaisses, la vitesse dudit ménisque variant fréquemment alors que ledit ménisque (M3a, M3b, M3c) se déplace depuis la première extrémité de ladite extrémité inférieure de ladite plaque de base vers l'autre extrémité de ladite extrémité inférieure de sorte que lesdites parties plus épaisses et lesdites parties plus minces apparaissent de manière alternée.

**17.** Plaque de circuit électronique formée par le procédé selon l'une quelconque des revendications 1 à 16, **caractérisée en ce que** le vernis de réserve liquide est appliqué sur ladite partie de base de manière telle que la plaque de base quitte ledit vernis de réserve liquide en ayant une mince couche de réserve formée sur la surface de ladite plaque de base, ladite plaque de base quittant ledit vernis de réserve liquide dans un plan vertical,

ladite couche de réserve comportant une couche d'extrémité inférieure et une couche médiane, ladite couche médiane étant formée sur la partie médiane de ladite plaque de base située entre ladite couche d'extrémité inférieure et l'extrémité supérieure de ladite plaque de base, ladite couche d'extrémité inférieure coupant le vernis de réserve liquide alors que ladite plaque de base quitte ledit vernis de réserve liquide,

l'épaisseur de ladite couche d'extrémité inférieure n'étant pas plus épaisse que celle de la couche médiane.

**18.** Plaque de circuit électronique selon la revendication 17, dans laquelle l'épaisseur de ladite couche d'extrémité inférieure varie de manière analogue à une onde sur la ligne horizontale de ladite partie d'extrémité inférieure de ladite plaque de base.

**19.** Plaque de circuit électronique selon la revendication 17, dans laquelle ladite couche d'extrémité inférieure comporte des parties plus minces et des parties plus épaisses, lesdites parties plus minces étant plus minces que lesdites parties plus épaisses, chacune desdites parties plus minces étant située entre une première desdites parties plus épaisses et une autre desdites parties plus épaisses qui est la suivante par rapport à ladite première desdites parties plus épaisses.

**20.** Plaque de circuit électronique selon la revendication 17, dans laquelle ladite couche d'extrémité inférieure comporte des parties plus minces et des parties plus épaisses, lesdites parties plus minces et lesdites parties plus épaisses apparaissant de manière alternée.

# FIG. 1

EP 0 863 437 B1

FIG. 2

EP 0 863 437 B1

FIG. 3

FIG. 4

FIG. 5

FIG. 6

FIG. 7

FIG. 8

FIG. 9

FIG. 10

EP 0 863 437 B1

FIG. 11

FIG. 12

FIG. 13

FIG. 14

FIG. 15

FIG. 16

FIG. 17

FIG. 18

EP 0 863 437 B1

FIG.19

FIG. 20

# FIG. 21

FIG. 22

FIG. 23

FIG. 24

FIG. 25

(a)

(b)

(c)

FIG. 26

(a)

(b)

FIG. 27

(a)

(b)

FIG. 28

M3a

M3b

M3c

Fig. 29

(a)

(b)

(c)

(d)

(e)

FIG. 30

FIG. 31

(a)    (b)

FIG. 32